# EUROPEAN PATENT APPLICATION

(11) **EP 4 586 783 A1**
(43) Date of publication of application: **16.07.2025**
(21) Application number: 23953635.2
(22) Date of filing: 28.09.2023
(51) Int. Cl.: H10K 59/131

(54) **DISPLAY PANEL AND DISPLAY DEVICE**

(71) Applicant: BOE Technology Group Co., Ltd., Beijing 100015 (CN); Chengdu BOE Optoelectronics Technology Co., Ltd., Chengdu, Sichuan 611731 (CN)
(72) Inventor: LIU, Cong, Beijing 100176 (CN); WANG, Xinxin, Beijing 100176 (CN); SONG, Gukhwan, Beijing 100176 (CN)
(74) Representative: Durán-Corretjer, S.L.P.
(86) International application number: PCT/CN2023/122501
(87) International publication number: WO 2025/065486

(57) **Abstract**

A display panel, comprising: a base (10), a plurality of sub-pixels (PX) and a plurality of data lines (DL) which are located in a display area (AA), and a plurality of multiplexing circuits (40), a plurality of multiplexing data lines (61) and a plurality of multiplexing control lines (51, 52, 53, 54, 55, 56, 57, 58, 59) which are located in a first frame area (B1), wherein the orthographic projections of the plurality of multiplexing data lines (61) and the plurality of multiplexing control lines (51, 52, 53, 54, 55, 56, 57, 58, 59) on the base (10) do not overlap; and the plurality of multiplexing data lines (61) comprise a first group of multiplexing data lines (61a) and a second group of multiplexing data lines (61b), a portion of at least one of the multiplexing control lines (51, 52, 53, 54, 55, 56, 57, 58, 59) being located between the first group of multiplexing data lines (61a) and the second group of multiplexing data lines (61b).

## Description

### Technical Field

The present disclosure relates to, but is not limited to, the field of display technologies, and particularly to a display panel and a display apparatus.

### Background

An Organic Light Emitting Diode (OLED for short) is an active light emitting display device and has advantages such as self-luminescence, a wide viewing angle, a high contrast ratio, low power consumption, and an extremely high response speed. With continuous development of display technologies, a display apparatus in which an OLED is used as a light emitting device and signal control is performed through a Thin Film Transistor (TFT for short) has become a mainstream product in the field of display at present.

### Summary

The following is a summary of subject matters described herein in detail. The summary is not intended to limit the protection scope of claims.

Embodiments of the present disclosure provide a display panel and a display apparatus.

In one aspect, an embodiment provides a display panel including a base substrate, multiple sub-pixels and multiple data lines, multiple multiplexing circuits, multiple multiplexing data lines, and multiple multiplexing control lines. The base substrate includes a display region and a first bezel region located on a side of the display region. The multiple sub-pixels and the multiple data lines are located in the display region and the multiple data lines are connected with the multiple sub-pixels and configured to provide data signals to the multiple sub-pixels. The multiple multiplexing circuits, the multiple multiplexing data lines, and the multiple multiplexing control lines are located in the first bezel region. One of the multiple multiplexing circuits is connected with at least two multiplexing control lines among the multiple multiplexing control lines, one of the multiple multiplexing data lines, and at least two data lines among the multiple data lines, and is configured to provide a data signal transmitted by the one reset data line to the at least two data lines under control of the at least two multiplexing control lines. An orthographic projection of the multiple multiplexing data lines on the base substrate is not overlapped with an orthographic projection of the multiple multiplexing control lines on the base substrate. The multiple multiplexing data lines are divided into a first set of multiplexing data lines and a second set of multiplexing data lines. A part of at least one multiplexing control line is located between the first set of multiplexing data lines and the second set of multiplexing data lines.

In some exemplary implementation modes, the first bezel region at least includes a first signal access region and a second signal access region, and the second signal access region is located on a side of the first signal access region away from the display region. The second signal access region is provided with multiple multiplexing control contact pads. The multiplexing control line includes a first sub-line, a second sub-line, and a third sub-line. The third sub-line is connected between the first sub-line and the second sub-line. The third sub-line is located in the first signal access region. The second sub-line is located on a side of the first signal access region close to the display region, and is located between the first set of multiplexing data lines and the second set of multiplexing data lines. The first sub-line is connected with a multiplexing control contact pad of the second signal access region.

In some exemplary implementation modes, the first signal access region is provided with multiple first multiplexing adapter pads and multiple second multiplexing adapter pads. The first sub-line of the multiplexing control line is connected with the third sub-line through one of the multiple first multiplexing adapter pads, and the second sub-line of the multiplexing control line is connected with the third sub-line through one of the multiple second multiplexing adapter pads.

In some exemplary implementation modes, the first signal access region has multiple sides, and the multiple first multiplexing adapter pads and the multiple second multiplexing adapter pads are arranged along a same side.

In some exemplary implementation modes, the first signal access region is further provided with a first set of data contact pads and a second set of data contact pads. The first set of data contact pads are connected with the first set of multiplexing data lines, and the second set of data contact pads are connected with the second set of multiplexing data lines. The multiple first multiplexing adapter pads are divided into a first set of first multiplexing adapter pads and a second set of first multiplexing adapter pads. The multiple second multiplexing adapter pads are located between the first set of data contact pads and the second set of data contact pads. The first set of first multiplexing adapter pads is located on a side of the first set of data contact pads away from the multiple second multiplexing adapter pads and the second set of first multiplexing adapter pads is located on a side of the second set of data contact pads away from the multiple second multiplexing adapter pads.

In some exemplary implementation modes, the first signal access region has at least a first side and a second side extending in a same direction, the second side is located on a side of the first side away from the display region; the multiple first multiplexing adapter pads are arranged along the second side, and the multiple second multiplexing adapter pads are arranged along the first side.

In some exemplary implementation modes, the multiple first multiplexing adapter pads and the multiple second multiplexing adapter pads are at least partially aligned in an extension direction of the second sub-line.

In some exemplary implementation modes, the first bezel region is provided with multiple Direct Current (DC) signal transmission lines. An orthographic projection of the first sub-line of the multiplexing control line on the base substrate is overlapped with an orthographic projection of at least one DC signal transmission line on the base substrate.

In some exemplary implementation modes, the second signal access region is further provided with multiple DC signal contact pads arranged in a first direction. The multiple DC signal contact pads are configured to be connected with the multiple DC signal transmission lines. The multiple multiplexing control contact pads are located on a side of the multiple DC signal contact pads close to an edge of the display panel.

In some exemplary implementation modes, the first bezel region is further provided with multiple square wave signal transmission lines, and an orthographic projection of the first sub-line of the multiplexing control line is further overlapped with an orthographic projection of at least one square wave signal transmission line on the base substrate.

In some exemplary implementation modes, the second signal access region is further provided with multiple square wave signal contact pads arranged in the first direction. The multiple square wave signal contact pads are configured to be connected with the multiple square wave signal transmission lines. At least one square wave signal contact pad is provided between the multiple multiplexing control contact pads and the multiple DC signal contact pads.

In some exemplary implementation modes, the first bezel region is provided with multiple DC signal transmission lines. An orthographic projection of the first sub-line of the multiplexing control line on the base substrate is not overlapped with an orthographic projection of the multiple DC signal transmission lines on the base substrate.

In some exemplary implementation modes, the second signal access region is further provided with multiple DC signal contact pads arranged in the first direction. The multiple DC signal contact pads are configured to be connected with the multiple DC signal transmission lines. The multiple multiplexing control contact pads are located on a side of the multiple DC signal contact pads away from an edge of the display panel.

In some exemplary implementation modes, the first bezel region is provided with a first power supply leading-out line and a first shielding electrode. The first shielding electrode is connected with the first power supply leading-out line. The first shielding electrode is located on a side of the first signal access region close to the display region. Second sub-lines of the multiple multiplexing control lines are divided into a first set of second sub-lines and a second set of second sub-lines. The first shielding electrode is located between the first set of second sub-lines and the second set of second sub-lines.

**In** some exemplary implementation modes, an orthographic projection of the first shielding electrode on the base substrate is not overlapped with an orthographic projection of the second sub-lines of the multiple multiplexing control lines on the base substrate.

**In** some exemplary implementation modes, the first bezel region is further provided with a second shielding electrode, the second shielding electrode is located on a side of the first shielding electrode away from the base substrate, and the second shielding electrode is electrically connected with the first shielding electrode. An orthographic projection of the second shielding electrode on the base substrate is at least partially overlapped with an orthographic projection of the first shielding electrode on the base substrate.

In some exemplary implementation modes, the second shielding electrode is located on a side of the second sub-lines of the multiple multiplexing control lines away from the base substrate, and the orthographic projection of the second shielding electrode on the base substrate is overlapped with an orthographic projection of a second sub-line of at least one multiplexing control line on the base substrate.

In another aspect, an embodiment provides a display apparatus, including the aforementioned display panel.

In some exemplary implementation modes, the display apparatus further includes a drive chip and a flexible circuit board which are connected with the display panel. The first bezel region of the display panel at least includes: a first signal access region and a second signal access region. The second signal access region is located on a side of the first signal access region away from a display region. An orthographic projection of the drive chip on the display panel is located in the first signal access region. At least a part of pins of the flexible circuit board are located in the second signal access region.

In another aspect, an embodiment provides a display panel including a base substrate, multiple sub-pixels, and multiple data lines, multiple multiplexing circuits, multiple multiplexing data lines, and multiple multiplexing control lines. The base substrate includes a display region and a first bezel region located on at least one side of the display region, the first bezel region at least includes a first signal access region, and the first signal access region is provided with multiple data contact pads. The multiple sub-pixels and the multiple data lines are located in the display region, and the multiple data lines are connected with the multiple sub-pixels and configured to provide data signals to the multiple sub-pixels. The multiple multiplexing circuits, the multiple multiplexing data lines, and the multiple multiplexing control lines are located in the first bezel region. One of the multiple multiplexing circuits is connected with at least two multiplexing control lines among the multiple multiplexing control lines, one of the multiple multiplexing data lines, and at least two data lines among the multiple data lines, and is configured to provide a data signal transmitted by the one reset data line to the at least two data lines under control of the at least two multiplexing control lines. The multiple multiplexing data lines are connected with the multiple data contact pads of the first signal access region. An orthographic projection of the multiple multiplexing data lines on the base substrate is not overlapped with an orthographic projection of the multiple multiplexing control lines on the base substrate. A part of at least one multiplexing control line is located in the first signal access region.

In some exemplary implementation modes, the first bezel region further includes a second signal access region, the second signal access region is located on a side of the first signal access region away from the display region, and the second signal access region is provided with multiple multiplexing control contact pads. The multiplexing control line includes a first sub-line, a second sub-line, and a third sub-line. The third sub-line is connected between the first sub-line and the second sub-line. The third sub-line is located in the first signal access region. The second sub-line is located on a side of the first signal access region close to the display region. The first sub-line is connected with a multiplexing control contact pad of the second signal access region.

In some exemplary implementation modes, third sub-lines of the multiple multiplexing control lines are divided into a first set of third sub-lines and a second set of third sub-lines, and the first set of third sub-lines and the second set of third sub-lines are arranged in the first direction. Extension directions of the third sub-lines of the multiple multiplexing control lines intersect with extension directions of second sub-lines.

In some exemplary implementation modes, the extension directions of the third sub-lines of the multiple multiplexing control lines are the same as the extension directions of the second sub-lines.

In some exemplary implementation modes, the multiple multiplexing data lines are divided into a first set of multiplexing data lines and a second set of multiplexing data lines. Second sub-lines of the multiple multiplexing control lines are divided into a first set of second sub-lines and a second set of second sub-lines. The first set of second sub-lines and the second set of second sub-lines are located between the first set of multiplexing data lines and the second set of multiplexing data lines. The first bezel region is provided with a first power supply leading-out line and a first shielding electrode and the first shielding electrode is connected with the first power supply leading-out line. The first shielding electrode is located on a side of the first signal access region close to the display region. The first shielding electrode is located between the first set of second sub-lines and the second set of second sub-lines.

In some exemplary implementation modes, the first bezel region is further provided with a second shielding electrode, the second shielding electrode is located on a side of the first shielding electrode away from the base substrate, and the second shielding electrode is electrically connected with the first shielding electrode. An orthographic projection of the second shielding electrode on the base substrate is at least partially overlapped with an orthographic projection of the first shielding electrode on the base substrate.

Other aspects may be comprehended after drawings and detailed description are read and understood.

### Brief Description of Drawings

The accompanying drawings are used for providing further understanding of technical solutions of the present disclosure, constitute a part of the specification, and are used for explaining the technical solutions of the present disclosure together with the embodiments of the present disclosure, but do not constitute limitations on the technical solutions of the present disclosure.
FIG. 1 is a schematic diagram of a display panel according to at least one embodiment of the present disclosure.
FIG. 2 is a schematic partial cross-sectional view of a display region of a display panel according to at least one embodiment of the present disclosure.
FIG. 3 is an equivalent circuit diagram of a multiplexing circuit according to at least one embodiment of the present disclosure.
FIG. 4 is an exemplary diagram of an arrangement of a multiplexing control line and a multiplexing data line according to at least one embodiment of the present disclosure.
FIG. 5A is a schematic partial plan view of a first bezel region according to at least one embodiment of the present disclosure.
FIG. 5B is a schematic partial plan view of a first bezel region according to at least one embodiment of the present disclosure.
FIG. 6A is a schematic top view of a multiplexing circuit according to at least one embodiment of the present disclosure.
FIG. 6B is a schematic diagram of the multiplexing circuit after forming a first source-drain metal layer in FIG. 6A.
FIG. 6C is a schematic diagram of the multiplexing circuit after forming a second gate metal layer in FIG. 6A.
FIG. 7 is an exemplary diagram of another arrangement of a multiplexing control line and a multiplexing data line according to at least one embodiment of the present disclosure.
FIG. 8 is an exemplary diagram of another arrangement of a multiplexing control line and a multiplexing data line according to at least one embodiment of the present disclosure.
FIG. 9 is an exemplary diagram of another arrangement of a multiplexing control line and a multiplexing data line according to at least one embodiment of the present disclosure.
FIG. 10 is an exemplary diagram of another arrangement of a multiplexing control line and a multiplexing data line according to at least one embodiment of the present disclosure.
FIG. 11 is an exemplary diagram of another arrangement of a multiplexing control line and a multiplexing data line according to at least one embodiment of the present disclosure.
FIG. 12 is a partial schematic view of a second fanout region according to at least one embodiment of the present disclosure.
FIG. 13 is another partial schematic view of a second fanout region according to at least one embodiment of the present disclosure.
FIG. 14 is another partial schematic view of a second fanout region according to at least one embodiment of the present disclosure.
FIG. 15 is a partial cross-sectional view taken along a direction Q-Q' in FIG. 14.
FIG. 16 is a schematic diagram of a display apparatus according to at least one embodiment of the present disclosure.

### Detailed Description

The embodiments of the present disclosure will be described below with reference to the accompanying drawings in detail. Implementation modes may be implemented in multiple different forms. Those of ordinary skills in the art may easily understand such a fact that modes and contents may be transformed into other forms without departing from the purpose and scope of the present disclosure. Therefore, the present disclosure should not be explained as being limited to contents recorded in following implementation modes only. The embodiments in the present disclosure and features in the embodiments may be combined randomly with each other if there is no conflict.

In the drawings, a size of one or more constituent elements, a thickness of a layer, or a region is exaggerated sometimes for clarity. Therefore, one mode of the present disclosure is not necessarily limited to the size, and shapes and sizes of one or more components in the drawings do not reflect actual scales. In addition, the accompanying drawings schematically illustrate ideal examples, and one mode of the present disclosure is not limited to shapes, numerical values, or the like shown in the drawings.

Ordinal numerals such as "first", "second", "third" in the specification are not set to form limits in quantity but only to avoid confusion between constituent elements. In the present disclosure, "plurality" represents two or more than two.

In the specification, for convenience, expressions "central", "above", "below", "front", "back", "vertical", "horizontal", "top", "bottom", "inside", "outside", etc., indicating directional or positional relationships are used to illustrate positional relationships between the constituent elements, not to indicate or imply that involved apparatuses or elements are required to have specific orientations and be structured and operated with the specific orientations but only to easily and simply describe the specification, and thus should not be understood as limitations on the present disclosure. The positional relationships between the constituent elements may be changed as appropriate according to a direction according to which each constituent element is described. Therefore, appropriate replacements based on situations are allowed, which is not limited to the expressions in the specification.

**In** the specification, unless otherwise specified and defined explicitly, terms "mount", "mutually connect", "connect", and "couple" should be understood in a broad sense. For example, it may be a fixed connection, a detachable connection, or an integral connection; it may be a mechanical connection or a connection; it may be a direct connection, an indirect connection through a middleware, or internal communication inside two elements. Those of ordinary skills in the art may understand meanings of the aforementioned terms in the present disclosure according to situations.

**In** the specification, an "electrical connection" includes a case that constituent elements are connected together through an element with a certain electrical action. The "element with a certain electrical action" is not particularly limited as long as electrical signals between the connected constituent elements may be transmitted. Examples of the "element with a certain electrical action" not only include an electrode and a wiring, but also include a switching element such as a transistor, a resistor, an inductor, a capacitor, another element with a plurality of functions, etc.

In the specification, a transistor refers to an element that at least includes three terminals, i.e., a gate electrode, a drain electrode, and a source electrode. The transistor has a channel region between the drain electrode (drain electrode terminal, drain region, or drain) and the source electrode (source electrode terminal, source region, or source), and a current can flow through the drain electrode, the channel region, and the source electrode. In the specification, the channel region refers to a region through which a current mainly flows.

In the specification, a first electrode may be a drain electrode, and a second electrode may be a source electrode. Or, the first electrode may be a source electrode, and the second electrode may be a drain electrode. In a case that transistors with opposite polarities are used, or in a case that a direction of a current changes during operation of a circuit, or the like, functions of the "source electrode" and the "drain electrode" are sometimes interchangeable. Therefore, the "source electrode" and the "drain electrode" are interchangeable in the specification. **In** addition, a gate may also be referred to as a control electrode.

**In** the specification, "parallel" refers to a state in which an angle formed by two straight lines is -10° or more and 10° or less, and thus also includes a state in which the angle is -5° or more and 5° or less. In addition, "perpendicular" refers to a state in which an angle formed by two straight lines is 80° or more and 100° or less, and thus also includes a state in which the angle is 85° or more and 95° or less.

In the specification, a circle, oval, triangle, rectangle, trapezoid, pentagon, or hexagon, etc. is not strictly speaking, but may be an approximate circle, oval, triangle, rectangle, trapezoid, pentagon, or hexagon, etc. Some small deformations due to tolerances may exist, for example, guide angles, curved edges, and deformations thereof may exist.

In the present disclosure, "about" and "substantially" refer to that a boundary is not defined strictly and a case within a range of process and measurement errors is allowed. In the present disclosure, "same" includes completely the same and substantially the same cases, and "substantially the same" refers to a case where an exponential value differs by less than 10%.

In the specification, "A extends along a B direction" means that A may include a main portion and a secondary portion connected with the main portion, the main portion is a line, a line segment, or a strip-shaped body, the main portion extends along the B direction, and a length of the main portion extending along the B direction is greater than a length of the secondary portion extending along another direction. "A extends along a B direction" in the specification always means "a main portion of A extends along a B direction".

"A and B are of a same layer structure" mentioned in the specification means that A and B are formed simultaneously through a same patterning process. A "same layer" does not always mean that thicknesses of layers or heights of layers are the same in a section diagram. "An orthographic projection of A contains an orthographic projection of B" means that the orthographic projection of B falls within a range of the orthographic projection of A, or the orthographic projection of A covers the orthographic projection of B.

With development of display technologies, increasing a screen-to-body ratio and reducing a bezel size is an important direction of improvement. Current display panels are usually provided with a multiplexing circuit (MUX) to reduce a quantity of data lines, thereby reducing the bezel size. Taking an application of display panels in wearable products such as watches as an example, the multiplexing circuit is very important to display quality of wearable products such as watches, especially in low-gray scale display, if a signal load of the multiplexing circuit is different, it will lead to poor display such as bright and dark stripes or split screen. For example, when for the multiplexing circuit, a design of 1:N (N is an odd number, for example N = 9) is adopted (that is, the multiplexing circuit provides a data signal of one multiplexing data line to at least N data lines under control of N multiplexing control lines), the N multiplexing control lines cannot be evenly divided into two groups for wiring, and there must be a difference in signal loads of the multiplexing control lines; when for the multiplexing circuit, a design of 1:M (M is an even number, for example M = 6) is adopted (that is, the multiplexing circuit provides a data signal of one multiplexing data line to at least M data lines under control of M multiplexing control lines), although the M multiplexing control lines may be evenly divided into two groups for wiring, and left and right uniform wiring is conducive to improving low gray scale image quality, in a case of extremely low gray scale, there will still be a split screen phenomenon in the display panel, which cannot meet a user's requirements for further improving image quality. Moreover, a signal load of a multiplexing control line of the multiplexing circuit is susceptible to other signals (e.g., data signals). Since a data signal is a high-frequency signal, crosstalk between a multiplexing control signal and a data signal will affect writing of the data signal adversely, resulting in an impact on displaying image quality and causing poor display on the display panel.

The embodiments provide a display panel and a display apparatus, which may reduce an influence of other signals (for example, data signals) on a multiplexing control signal transmitted by a multiplexing control line, and is conducive to improving uniformity of image quality of the display panel.

An embodiment provides a display panel, including a base substrate, multiple sub-pixels, and multiple data lines, multiple multiplexing circuits, multiple multiplexing data lines, and multiple multiplexing control lines. The base substrate includes a display region and a first bezel region located on at least one side of the display region. The multiple sub-pixels and the multiple data lines are located in the display region, and the multiple data lines are connected with the multiple sub-pixels and configured to provide data signals to the multiple sub-pixels. The multiple multiplexing circuits, the multiple multiplexing data lines, and the multiple multiplexing control lines are located in the first bezel region. A multiplexing circuit is connected with at least two multiplexing control lines among the multiple multiplexing control lines, one multiplexing data line, and at least two data lines among the multiple data lines, and is configured to provide a data signal transmitted by the one reset data line to the at least two data lines under control of the at least two multiplexing control lines. An orthographic projection of the multiple multiplexing data lines on the base substrate is not overlapped with an orthographic projection of the multiple multiplexing control lines on the base substrate. The multiple multiplexing data lines are divided into a first set of multiplexing data lines and a second set of multiplexing data lines. A part of at least one multiplexing control line is located between the first set of multiplexing data lines and the second set of multiplexing data lines. In some examples, a part of each of the multiple multiplexing control lines may be located between the first set of multiplexing data lines and the second set of multiplexing data lines. Or, a part of several multiplexing control lines among the multiple multiplexing control lines may be located between the first set of multiplexing data lines and the second set of multiplexing data lines, and rest multiplexing control lines may be bypassed from an outside of the first set of multiplexing data lines and the second set of multiplexing data lines.

**In** some examples, for the multiplexing circuit, a 1:n design may be adopted, i.e., the multiplexing circuit may provide a data signal of one multiplexing data line to at least n data lines under control of n multiplexing control lines. Among them, n may be an integer greater than 1, for example n may be 2, 3, 6, or 9. The present embodiment is not limited thereto.

A wiring mode of the multiplexing control lines of the display panel of the embodiment may avoid being overlapped with the multiple multiplexing data lines, may reduce an influence of the multiplexing data lines on multiplexing control signals transmitted by the multiplexing control lines, and is conducive to improving display quality of the display panel.

In some exemplary implementation modes, the first bezel region may at least include a first signal access region and a second signal access region, and the second signal access region may be located on a side of the first signal access region away from the display region. The second signal access region is provided with multiple multiplexing control contact pads. A multiplexing control line may include a first sub-line, a second sub-line, and a third sub-line, and the third sub-line is connected between the first sub-line and the second sub-line. The third sub-line may be located in the first signal access region. The second sub-line may be located on a side of the first signal access region close to the display region and located between the first set of multiplexing data lines and the second set of multiplexing data lines. The first sub-line is connected with a multiplexing control contact pad of the second signal access region. In this example, a third sub-line of at least one multiplexing control line is arranged in the first signal access region, so that being overlapped with multiple multiplexing data lines may be avoided, and a coupling capacitance caused by overlapping between a multiplexing data line and a multiplexing control line may be eliminated; moreover, a second sub-line of at least one multiplexing control line may be located between the first set of multiplexing data lines and the second set of multiplexing data lines, without being overlapped with the multiplexing data lines, and a certain interval distance may be maintained from the multiplexing data lines, so that a coupling capacitance between the multiplexing control line and the multiplexing data line in three-dimensional space may be reduced, and display quality at extremely low gray scale may be guaranteed.

In some exemplary implementation modes, the first signal access region may be provided with multiple first multiplexing adapter pads and multiple second multiplexing adapter pads. The first sub-line of the multiplexing control line is connected with the third sub-line through a first multiplexing adapter pad, and the second sub-line of the multiplexing control line is connected with the third sub-line through a second multiplexing adapter pad. This example achieves a connection between the first sub-line and the third sub-line and a connection between the second sub-line and the third sub-line by disposing the first multiplexing adapter pad and the second multiplexing adapter pad in the first signal access region, which not only ensures effectiveness of a connection, but also helps to ensure uniformity of a film layer pattern in the first signal access region.

In some exemplary implementation modes, the first signal access region may have multiple sides, and the multiple first multiplexing adapter pads and the multiple second multiplexing adapter pads may be arranged along a same side. In some examples, the first signal access region may also be provided with a first set of data contact pads and a second set of data contact pads. The first set of data contact pads is connected with the first set of multiplexing data lines and the second set of data contact pads is connected with the second set of multiplexing data lines. The multiple first multiplexing adapter pads may be divided into a first set of first multiplexing adapter pads and a second set of first multiplexing adapter pads. The multiple second multiplexing adapter pads are located between the first set of data contact pads and the second set of data contact pads. The first set of first multiplexing adapter pads may be located on a side of the first set of data contact pads away from the multiple second multiplexing adapter pads, and the second set of first multiplexing adapter pads may be located on a side of the second set of data contact pads away from the multiple second multiplexing adapter pads. An arrangement mode of the first multiplexing adapter pads and the second multiplexing adapter pads in this example may facilitate wiring in the first signal access region.

In some exemplary implementation modes, the first signal access region may at least have a first side and a second side extending in a same direction, and the second side is located on a side of the first side away from the display region. The multiple first multiplexing adapter pads may be arranged along the second side and the multiple second multiplexing adapter pads may be arranged along the first side. In some examples, the multiple first multiplexing adapter pads and the multiple second multiplexing adapter pads are at least partially aligned in an extension direction of the second sub-line. An arrangement mode of the first multiplexing adapter pad and the second multiplexing adapter pad in this example may help to reduce overlap between the first sub-line of the multiplexing control line and other signal traces.

In some exemplary implementation modes, the first bezel region may be provided with multiple Direct Current (DC) signal transmission lines. An orthographic projection of the first sub-line of the multiplexing control line on the base substrate may be overlapped with an orthographic projection of at least one DC signal transmission line on the base substrate. In some examples, the second signal access region may also be provided with multiple DC signal contact pads arranged in a first direction. The multiple DC signal contact pads are configured to be connected with the multiple DC signal transmission lines. The multiple multiplexing control contact pads are located on a side of the multiple DC signal contact pads close to an edge of the display panel. In some examples, the DC signal transmission line may include a first power supply leading-out line and a second power supply leading-out line, the first power supply leading-out line may be configured to transmit a high potential signal, and the second power supply leading-out line may be configured to transmit a low potential signal. In this example, the multiplexing control line is provided to be overlapped with the DC signal transmission line to perform wiring, which is conducive to reducing overlap between the multiplexing control line and rest signal traces, and reducing crosstalk of multiplexing control signals.

In some exemplary implementation modes, the first bezel region may also be provided with multiple square wave signal transmission lines, and an orthographic projection the first sub-line of the multiplexing control line on the base substrate may also be overlapped with an orthographic projection of at least one square wave signal transmission line on the base substrate. In some examples, the second signal access region is further provided with multiple square wave signal contact pads arranged in the first direction. The multiple square wave signal contact pads are configured to be connected with the multiple square wave signal transmission lines. At least one square wave signal contact pad may be provided between the multiple multiplexing control contact pads and the multiple DC signal contact pads. In some examples, the square wave signal transmission lines may include a control signal line that provides a control signal to a gate drive circuit. An arrangement mode of this example may facilitate wiring of the multiplexing control line.

In some exemplary implementation modes, the first bezel region is provided with multiple DC signal transmission lines. An orthographic projection of the first sub-line of the multiplexing control line on the base substrate may be not overlapped with an orthographic projection of the multiple DC signal transmission lines on the base substrate. In some examples, the second signal access region is also provided with multiple DC signal contact pads arranged in the first direction. The multiple DC signal contact pads are configured to be connected with the multiple DC signal transmission lines. The multiple multiplexing control contact pads may be located on a side of the multiple DC signal contact pads away from an edge of the display panel. This example may reduce overlap between the multiplexing control line and rest signal traces except the multiplexing data line, thereby avoiding crosstalk of the multiplexing control signal by rest signals.

In some exemplary implementation modes, the first bezel region is provided with a first power supply leading-out line and a first shielding electrode, and the first shielding electrode is connected with the first power supply leading-out line. The first shielding electrode is located on a side of the first signal access region close to the display region. Second sub-lines of the multiple multiplexing control lines may be divided into a first set of second sub-lines and a second set of second sub-lines. The first shielding electrode may be located between the first set of second sub-lines and the second set of second sub-lines. In this example, by providing the first shielding electrode, crosstalk of the multiplexing control signal may be reduced.

In some exemplary implementation modes, the first bezel region may also be provided with a second shielding electrode, and the second shielding electrode is located on a side of the first shielding electrode away from the base substrate. The second shielding electrode is electrically connected with the first shielding electrode. An orthographic projection of the second shielding electrode on the base substrate is at least partially overlapped with an orthographic projection of the first shielding electrode on the base substrate. In some examples, the second shielding electrode is located on a side of the second sub-lines of the multiple multiplexing control lines away from the base substrate, and the orthographic projection of the second shielding electrode on the base substrate may be overlapped with an orthographic projection of a second sub-line of at least one multiplexing control line on the base substrate. In this example, by providing the second shielding electrode, an influence of a data signal, other external signals, or an electric field on the multiplexing control signal may be shielded.

Solutions of the embodiment will be described below through multiple examples.

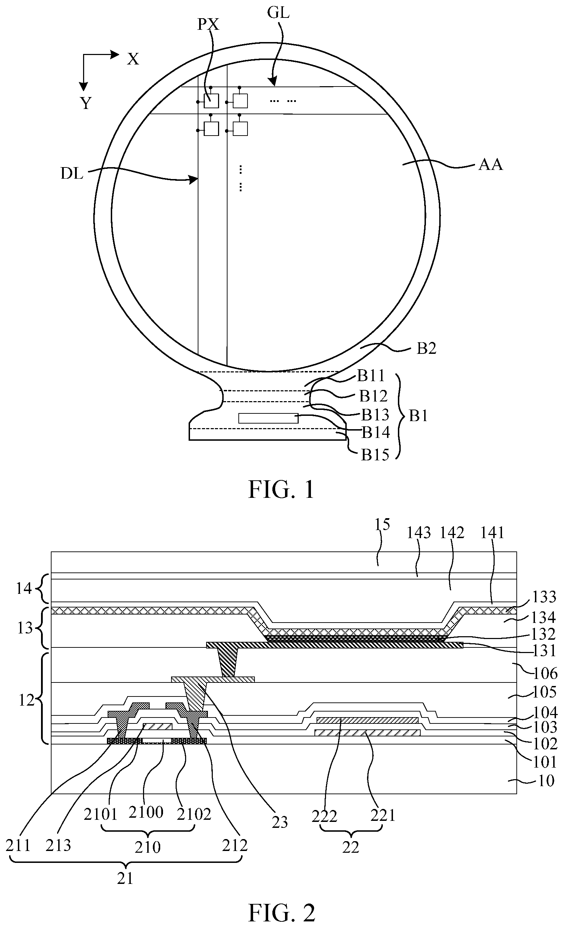

FIG. 1 is a schematic diagram of a display panel according to at least one embodiment of the present disclosure. In some examples, as shown in FIG. 1, the display panel may include a display region AA, a first bezel region B1 located on a side of the display region AA, and a second bezel region B2 located on other side(s) of the display region AA. The first bezel region B1 may be communicated with the second bezel region B2. For example, the first bezel region B1 may be a lower bezel of the display panel, and the second bezel region B2 may include other bezel regions of the display panel other than the lower bezel.

In some examples, as shown in FIG. 1, the display region AA may be a planar region including multiple sub-pixels PX forming a pixel array, the multiple sub-pixels PX may be configured to display a dynamic picture or a static image. The display region AA may be referred to as an Active Area. In some examples, the display region AA may be a circle or an oval. However, the present embodiment is not limited thereto. For example, the display region may be rectangular or have other shapes. In some examples, the display panel may be a flexible panel, and accordingly the display panel may be deformable, for example, may be crimped, bent, folded, or curled.

In some examples, as shown in FIG. 1, the display region AA may include a display structure layer disposed on a base substrate, or may include a display structure layer and a touch structure layer disposed sequentially on the base substrate. For example, the display panel may integrate a touch structure to form a structure of the touch structure on thin film encapsulation (Touch on Thin Film Encapsulation, referred to as Touch on TFE). The structure of Touch on TFE mainly includes a Flexible Multi-Layer On Cell (FMLOC for short) structure and a Flexible Single-Layer On Cell (FSLOC for short) structure. The FMLOC structure is based on a working principle of mutual capacitance detection. Generally, a drive (Tx) electrode and a sensing (Rx) electrode are formed by two layers of metal, and a drive chip (IC) achieves a touch action by detecting a mutual capacitance between the drive electrode and the sensing electrode. The FSLOC structure is based on a working principle of self-capacitance (or voltage) detection. Generally, a touch electrode is formed by a single layer of metal, and an integrated circuit achieves a touch action by detecting a self-capacitance (or voltage) of the touch electrode.

In some examples, the display structure layer may include multiple sub-pixels PX, multiple gate lines GL, and multiple data lines DL. The multiple gate lines GL may be arranged in a second direction Y, and each gate line GL may extend in a first direction X. The multiple data lines DL may be arranged in the first direction X, and each data line DL may extend in the second direction Y. An orthographic projection of the multiple gate lines GL on the base substrate may intersect with an orthographic projection of the multiple data lines DL on the base substrate, thereby forming multiple sub-pixel regions. One sub-pixel PX may be provided within one sub-pixel region. The multiple data lines DL may be electrically connected with the multiple sub-pixels PX and the multiple data lines DL may be configured to provide data signals to the multiple sub-pixels PX. The multiple gate lines GL may be electrically connected with the multiple sub-pixels PX and the multiple gate lines GL may be configured to provide gate drive signals to the multiple sub-pixels PX. For example, the gate drive signals may include a scan signal, or may include a scan signal and a light emitting control signal, or may include a scan signal, a reset control signal, and a light emitting control signal.

In some examples, as shown in FIG. 1, the first direction X may be an extension direction (e.g., a row direction) of the gate lines GL in the display region AA, and the second direction Y may be an extension direction (e.g., a column direction) of the data lines DL in the display region AA. The first direction X and the second direction Y may intersect with each other, for example, they may be perpendicular to each other.

In some examples, one pixel unit of the display region AA may include three sub-pixels, the three sub-pixels may be a first sub-pixel emitting first color light (e.g., red light), a second sub-pixel emitting second color light (e.g., green light), and a third sub-pixel emitting third color light (e.g., blue light), respectively. However, the present embodiment is not limited thereto. In some examples, one pixel unit may include four sub-pixels, and the four sub-pixels may be a sub-pixel emitting red light, a sub-pixel emitting green light, a sub-pixel emitting blue light, and a sub-pixel emitting white light, respectively. For another example, one pixel unit may include four sub-pixels, and the four sub-pixels may include one sub-pixel emitting red light, one sub-pixel emitting blue light, and two sub-pixels emitting green light.

In some examples, one sub-pixel may include a pixel circuit and a light emitting element electrically connected with the pixel circuit. The pixel circuit may include multiple transistors and at least one capacitor. For example, the pixel circuit may be of a 3T1C, 4T1C, 5T1C, 5T2C, 6T1C, 7T1C, or 8T1C structure. In the above circuit structure, T refers to a thin film transistor, C refers to a capacitor, a number before T represents a quantity of thin film transistors in the circuit, and a number before C represents a quantity of capacitors in the circuit.

In some examples, the multiple transistors in the pixel circuit may be P-type transistors or may be N-type transistors. Adopting a same type of transistors in the pixel circuit may simplify a process flow, reduce process difficulties of the display panel, and improve a yield of products. In some other examples, the multiple transistors in the pixel circuit may include a P-type transistor and an N-type transistor.

In some examples, low temperature poly silicon thin film transistors, or oxide thin film transistors, or both of a low temperature poly silicon thin film transistor and an oxide thin film transistor may be as adopted for the multiple transistors in the pixel circuit. Low Temperature Poly Silicon (LTPS) is adopted for an active layer of a low temperature poly silicon thin film transistor and an oxide semiconductor (Oxide) is adopted for an active layer of an oxide thin film transistor. The low temperature poly silicon thin film transistor has advantages such as a high migration rate and fast charging, and the oxide thin film transistor has advantages such as a low leakage current. The low temperature poly silicon thin film transistor and the oxide thin film transistor are integrated on one display panel, that is, an LTPS + Oxide (LTPO for short) display panel, so that advantages of both the low temperature poly silicon thin film transistor and the oxide thin film transistor may be utilized, low-frequency drive may be achieved, power consumption may be reduced, and display quality may be improved.

In some examples, the light emitting element may be any of a Light Emitting Diode (LED), an Organic Light Emitting Diode (OLED), a Quantum dot Light Emitting Diode (QLED), a micro LED (including: mini-LED or micro-LED), and the like. For example, the light emitting element may be an OLED, and the light emitting element may emit red light, green light, blue light, or white light, etc. under drive of a pixel circuit corresponding to the light emitting element. A color of light emitted by the light emitting element may be determined as required. In some examples, the light emitting element may include an anode, a cathode, and an organic emitting layer located between the anode and the cathode. The anode of the light emitting element may be electrically connected with a corresponding pixel circuit. However, the present embodiment is not limited thereto.

In some examples, a shape of a light emitting element of a sub-pixel may be a rectangle, a rhombus, a pentagon, or a hexagon. When one pixel unit includes three sub-pixels, light emitting elements of the three sub-pixels may be arranged side by side horizontally, side by side vertically, or in a delta arrangement. When one pixel unit includes four sub-pixels, light emitting elements of the four sub-pixels may be arranged side by side horizontally, side by side vertically, or in a manner to form a square. However, the present embodiment is not limited thereto.

FIG. 2 is a schematic partial cross-sectional view of a display region of a display panel according to at least one embodiment of the present disclosure. FIG. 2 is illustrated by taking a structure of one sub-pixel of the display region as an example. **In** this example, description is given by taking a case that multiple transistors in a pixel circuit are of a same type as an example. For example, the multiple transistors in a pixel circuit may all be low temperature poly silicon thin film transistors or may all be oxide thin film transistors.

**In** some examples, as shown in FIG. 2, in a direction perpendicular to the display panel, the display region of the display panel may include a base substrate 10, and a circuit structure layer 12, a light emitting structure layer 13, an encapsulation structure layer 14, a touch structure layer 15 that are sequentially disposed on the base substrate 10. The display structure layer may at least include a circuit structure layer 12 and a light emitting structure layer 13. The circuit structure layer 12 may include at least pixel circuits of multiple sub-pixels, and a pixel circuit of each sub-pixel may include multiple transistors and at least one capacitor. The light emitting structure layer 13 may include at least light emitting elements of multiple sub-pixels.

**In** some examples, FIG. 2 is illustrated by taking a case in which one thin film transistor 21 and one capacitor 22 are included in one sub-pixel as an example. **In** some examples, the circuit structure layer 12 of the display region may include a semiconductor layer, a first gate metal layer, a second gate metal layer, a first source-drain metal layer, and a second source-drain metal layer provided on the base substrate 10. A first gate insulation layer 101 may be provided between the semiconductor layer and the first gate metal layer, a second gate insulation layer 102 may be provided between the first gate metal layer and the second gate metal layer, an interlayer dielectric layer 103 may be provided between the second gate metal layer and the first source-drain metal layer, a passivation layer 104 and a first planarization layer 105 may be provided between the first source-drain metal layer and the second source-drain metal layer, and a second planarization layer 106 may be provided on a side of the second source-drain metal layer away from the base substrate 10. The first gate insulation layer 101, the second insulation layer 102, the interlayer dielectric layer 103, and the passivation layer 104 may be inorganic insulation layers, and the first planarization layer 105 and the second planarization layer 106 may be organic insulation layers. However, the present embodiment is not limited thereto. In some other examples, a side of the semiconductor layer close to the base substrate may also be provided with a buffer layer, and the buffer layer may prevent harmful substances in the base substrate from intruding into interior of the display panel, and may also increase adhesion of a film layer in the display panel on the base substrate. In some other examples, the passivation layer may be omitted between the first source-drain metal layer and the second source-drain metal layer, and only the first planarization layer may be provided. In some other examples, the second source-drain metal layer and the second planarization layer may be omitted.

In some examples, as shown in FIG. 2, the semiconductor layer of the display region may at least include an active layer 210 of the thin film transistor 21. The active layer 210 of the thin film transistor 21 may include a first region 2101, a second region 2102, and a channel region 2100 located between the first region 2101 and the second region 2102. The first gate metal layer may at least include a gate 213 of the thin film transistor 21 and a first electrode plate 221 of the capacitor 22. An orthographic projection of the gate 213 of the thin film transistor 21 on the base substrate 10 may cover an orthographic projection of the channel region 2100 of the active layer 210 on the base substrate 10. The second gate metal layer may include at least a second electrode plate 222 of the capacitor 22. An orthographic projection of the second electrode plate 222 of the capacitor 22 on the base substrate may be at least partially overlapped with an orthographic projection of the first electrode plate 221 of the capacitor 22 on the base substrate 10, for example, the two may coincide. The first source-drain metal layer may at least include a first electrode 211 and a second electrode 212 of the thin film transistor 21. The interlayer dielectric layer 103 may be provided with multiple vias (for example, including a first pixel via and a second pixel via) in the display region, and the interlayer dielectric layer 103, the second gate insulation layer 102, and the first gate insulation layer 101 in the first pixel via may be removed to expose at least part of a surface of the first region 2101 of the active layer 210; the interlayer dielectric layer 103, the second gate insulation layer 102, and the first gate insulation layer 101 within the second pixel via may be removed to expose at least part of a surface of the second region 2102 of the active layer 210. The first electrode 211 of the thin film transistor 21 may be electrically connected with the first region 2101 of the active layer 210 through the first pixel via, and the second electrode 212 may be electrically connected with the second region 2102 of the active layer 210 through the second pixel via. The second source-drain metal layer may at least include an anode connection electrode 23. The anode connection electrode 23 may be connected with the second electrode 212 of the thin film transistor 21 through a via opened in the passivation layer 104 and the first planarization layer 105. In some examples, a gate line of the display region may be located in the first gate metal layer for example, and a data line and a high potential power supply line of the display region may be located in the second source-drain metal layer for example. However, the present embodiment is not limited thereto. In some other examples, the second source-drain metal layer may be omitted, and the data line and the high potential power supply line of the display region may be located in the first source-drain metal layer.

In some examples, as shown in FIG. 2, the light emitting structure layer 13 may include a pixel definition layer 134 and multiple light emitting elements. For example, each light emitting element may include a first electrode 131, an organic emitting layer 132, and a second electrode 133 that are stacked. The first electrode 131 of the light emitting element may be an anode, the first electrode 131 may be provided on the second planarization layer 106 and electrically connected with the anode connection electrode 23 through a pixel via opened in the second planarization layer 106. The pixel definition layer 134 is provided on the first electrode 131 and the second planarization layer 106, the pixel definition layer 134 may be provided with multiple pixel openings, and one pixel opening may expose at least part of a surface of one corresponding first electrode 131. At least part of the organic emitting layer 132 may be provided within one pixel opening and connected with a corresponding first electrode 131. The second electrode 133 may be provided on the organic emitting layer 132 and be connected with the organic emitting layer 132. The organic emitting layer 132 may be driven by the first electrode 131 and the second electrode 133 to emit light of a corresponding color.

In some examples, the organic emitting layer 132 of the light emitting element may include an Emitting Layer (EML), and include one or more film layers of a Hole Injection Layer (HIL), a Hole Transport Layer (HTL), a Hole Block Layer (HBL), an Electron Block Layer (EBL), an Electron Injection Layer (EIL), and an Electron Transport Layer (ETL). When driven by voltages of the first electrode 131 and the second electrode 133, light may be emitted according to a required gray scale, in virtue of light emitting characteristics of an organic material.

In some examples, light emitting layers of light emitting elements emitting light of different colors may be different. For example, a red light emitting element includes a red light emitting layer, a green light emitting element includes a green light emitting layer, and a blue light emitting element includes a blue light emitting layer. In order to reduce a process difficulty and improve a yield, a common layer may be adopted for a hole injection layer and a hole transport layer located on a side of an emitting layer, and a common layer may be adopted for an electron injection layer and an electron transport layer located on another side of the emitting layer. In some examples, any one or more layers of the hole injection layer, the hole transport layer, the electron injection layer, and the electron transport layer may be made in one process (one evaporation process or one inkjet printing process), and isolation may be achieved by means of a formed film layer surface segment difference or by means of a surface treatment. For example, any one or more of hole injection layers, hole transport layers, electron injection layers, and electron transport layers corresponding to adjacent sub-pixels may be isolated. **In** some examples, the organic emitting layer may be prepared and formed through evaporation using a Fine Metal Mask (FMM) or an open mask, or prepared and formed using an inkjet process.

In some examples, as shown in FIG. 2, the encapsulation structure layer 14 may include a first encapsulation layer 141, a second encapsulation layer 142, and a third encapsulation layer 143 that are stacked. The first encapsulation layer 141 and the third encapsulation layer 143 may be made of an inorganic material, the second encapsulation layer 142 may be made of an organic material, and the second encapsulation layer 142 may be provided between the first encapsulation layer 141 and the third encapsulation layer 143 to ensure that external water vapor cannot enter the light emitting element. However, the present embodiment is not limited thereto. For example, an encapsulation structure layer may be of a five-layer stacked structure of inorganic/organic/inorganic/organic/inorganic.

In some examples, the touch structure layer 15 may include multiple touch units. At least one touch unit may include at least one touch electrode. An orthographic projection of the at least one touch electrode on the base substrate may include an orthographic projection of the multiple sub-pixels on the base substrate. When the touch unit includes multiple touch electrodes, the multiple touch electrodes may be provided at intervals, and adjacent touch electrodes may be connected with each other through a connection portion. A touch electrode and the connection portion may be of a same layer structure. In some examples, the touch electrode may be in a shape of a rhombus, such as a regular rhombus, a horizontally long rhombus, or a longitudinally long rhombus. However, the present embodiment is not limited thereto. In some examples, the touch electrode may be in any one or more shapes of a triangle, a square, a trapezoid, a parallelogram, a pentagon, a hexagon, and another polygon.

In some examples, as shown in FIG. 1, the first bezel region B1 may include a first fanout region B11, a bending region B12, a second fanout region B13, a first signal access region B14, and a second signal access region B15 disposed sequentially along a direction away from the display region AA. The first fanout region B11 may be communicated with the second bezel region B2 and be located on a side of the display region AA. The first fanout region B11 may be provided with multiple multiplexing circuits. The bending region B12 may be communicated with the first fanout region B11 and the second fanout region B13, and is located on a side of the first fanout region B11 away from the display region AA. The second fanout region B13 may be located on a side of the bending region B12 away from the display region AA. The first signal access region B14 may be located on a side of the second fanout region B13 away from the display region AA. The second signal access region B15 may be located on a side of the first signal access region B14 away from the display region AA.

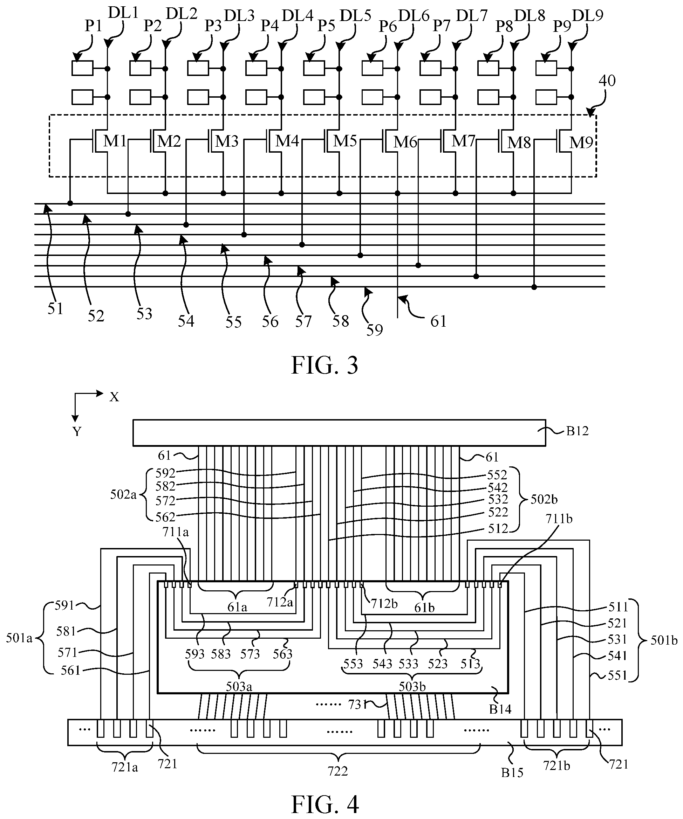

FIG. 3 is an equivalent circuit diagram of a multiplexing circuit according to at least one embodiment of the present disclosure. FIG. 3 is illustrated by taking a case in which a 1:9 design is adopted for a multiplexing circuit 40 as an example. In some examples, as shown in FIG. 3, one multiplexing circuit 40 may be electrically connected with nine multiplexing control lines (e.g., including a first multiplexing control line 51 to a ninth multiplexing control line 59), one multiplexing data line 61, and multiple data lines (e.g., including a first data line DL1 to a ninth data line DL9). The multiplexing circuit 40 may include nine multiplexing transistors (i.e., a first multiplexing transistor M1 to a ninth multiplexing transistor M9). Gates of the nine multiplexing transistors may be connected with different multiplexing control lines, i.e., a gate of the first multiplexing transistor M1 is connected with the first multiplexing control line 51, a gate of the second multiplexing transistor M2 is connected with the second multiplexing control line 52, a gate of the third multiplexing transistor M3 is connected with the third multiplexing control line 53, a gate of the fourth multiplexing transistor M4 is connected with the fourth multiplexing control line 54, a gate of the fifth multiplexing transistor M5 is connected with the fifth multiplexing control line 55, a gate of the sixth multiplexing transistor M6 is connected with the sixth multiplexing control line 56, a gate of the seventh multiplexing transistor M7 is connected with the seventh multiplexing control line 57, a gate of the eighth multiplexing transistor M8 is connected with the eighth multiplexing control line 58, and a gate of the ninth multiplexing transistor M9 is connected with the ninth multiplexing control line 59.

In some examples, first electrodes of the nine multiplexing transistors may all be connected with a same multiplexing data line 61. Second electrodes of the nine multiplexing transistors are respectively connected with different data lines of the display region. For example, a second electrode of the first multiplexing transistor M1 is connected with the first data line DL1, a second electrode of the second multiplexing transistor M2 is connected with the second data line DL2, a second electrode of the third multiplexing transistor M3 is connected with the third data line DL3, a second electrode of the fourth multiplexing transistor M4 is connected with the fourth data line DL4, a second electrode of the fifth multiplexing transistor M5 is connected with the fifth data line DL5, a second electrode of the sixth multiplexing transistor M6 is connected with the sixth data line DL6, a second electrode of the seventh multiplexing transistor M7 is connected with the seventh data line DL7, a second electrode of the eighth multiplexing transistor M8 is connected with the eighth data line DL8, and a second electrode of the ninth multiplexing transistor M9 is connected with the ninth data line DL9.

In some examples, the first data line DL1 may be connected with a first set of sub-pixels P1 and configured to provide a data signal to the first set of sub-pixels P1. The second data line DL2 may be connected with a second set of sub-pixels P2 and configured to provide a data signal to the second set of sub-pixels P2. The third data line DL3 may be connected with a third set of sub-pixels P3 and configured to provide a data signal to the third set of sub-pixels P3. The fourth data line DL4 may be connected with a fourth set of sub-pixels P4 and configured to provide a data signal to the fourth set of sub-pixels P4. The fifth data line DL5 may be connected with a fifth set of sub-pixels P5 and configured to provide a data signal to the fifth set of sub-pixels P5. The sixth data line DL6 may be connected with a sixth set of sub-pixels P6 and configured to provide a data signal to the sixth set of sub-pixels P6. The seventh data line DL17 may be connected with a seventh set of sub-pixels P7 and configured to provide a data signal to the seventh set of sub-pixels P7. The eighth data line DL8 may be connected with an eighth set of sub-pixels P18 and configured to provide a data signal to the eighth set of sub-pixels P8. The ninth data line DL9 may be connected with a ninth set of sub-pixels P9 and configured to provide a data signal to the ninth set of sub-pixels P9.

In some examples, one set of sub-pixels may include at least one column of sub-pixels of the display region. A column of sub-pixels may include, for example, multiple sub-pixels arranged in the second direction Y. For example, the first set of sub-pixels P1, the fourth set of sub-pixels P4, and the seventh set of sub-pixels P7 may be configured to emit first color light, the second set of sub-pixels P2, the fifth set of sub-pixels P5, and the eighth set of sub-pixels P8 may be configured to emit second color light, and the third set of sub-pixels P3, the sixth set of sub-pixels P6, and the ninth set of sub-pixels P9 may be configured to emit third color light. For example, the first color light may be red light, the second color light may be green light, and the third color light may be blue light. The present embodiment is not limited thereto.

In some examples, the nine multiplexing control lines may control multiple multiplexing circuits 40 to provide data signals to sub-pixels of the display region. As shown in FIG. 3, the first multiplexing control line 51 may be configured to provide a first multiplexing control signal, controlling a multiplexing circuit 40 to provide a data signal to the first set of sub-pixels P1. The second multiplexing control line 52 may be configured to provide a second multiplexing control signal, controlling a multiplexing circuit 40 to provide a data signal to the second set of sub-pixels P2. The third multiplexing control line 53 may be configured to provide a third multiplexing control signal, controlling a multiplexing circuit 40 to provide a data signal to the third set of sub-pixels P3. The fourth multiplexing control line 54 may be configured to provide a fourth multiplexing control signal, controlling a multiplexing circuit 40 to provide a data signal to the fourth set of sub-pixels P4. The fifth multiplexing control line 55 may be configured to provide a fifth multiplexing control signal, controlling a multiplexing circuit 40 to provide a data signal to the fifth set of sub-pixels P5. The sixth multiplexing control line 56 may be configured to provide a sixth multiplexing control signal, controlling a multiplexing circuit 40 to provide a data signal to the sixth set of sub-pixels P6. The seventh multiplexing control line 57 may be configured to provide a seventh multiplexing control signal, controlling a multiplexing circuit 40 to provide a data signal to the seventh set of sub-pixels P7. The eighth multiplexing control line 58 may be configured to provide an eighth multiplexing control signal, controlling a multiplexing circuit 40 to provide a data signal to the eighth set of sub-pixels P8. The ninth multiplexing control line 59 may be configured to provide a ninth multiplexing control signal, controlling a multiplexing circuit 40 to provide a data signal to the ninth set of sub-pixels P9.

FIG. 4 is an exemplary diagram of an arrangement of a multiplexing control line and a multiplexing data line according to at least one embodiment of the present disclosure. FIG. 4 is illustrated by taking a case of only several multiplexing data lines as an example. FIG. 4 is a schematic diagram showing a general trend of a multiplexing control line and a multiplexing data line in a second fanout region of the display panel. In this embodiment, a quantity of multiplexing data lines is not limited. This example is illustrated by taking a case in which a 1:9 design shown in FIG. 3 is adopted for a multiplexing circuit as an example.

In some examples, multiple multiplexing data lines 61 may be located on a side of the first signal access region B14 close to the bending region B12. The multiple multiplexing data lines 61 may be divided into a first set of multiplexing data lines 61a and a second set of multiplexing data lines 61b. The multiple multiplexing data lines 61 may be connected with multiple data bending connection lines within the bending region B12. The multiple multiplexing data lines 61 may extend substantially in the second direction Y and extend to be connected with multiple data contact pads within the first signal access region B14.

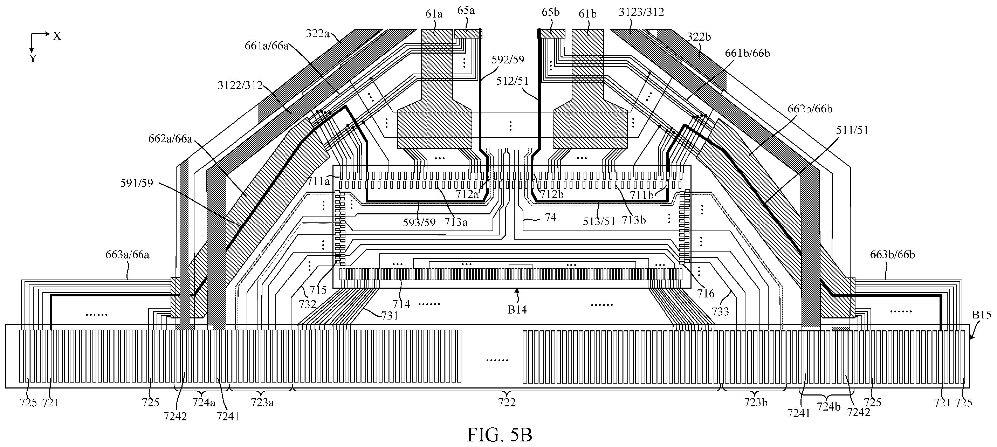

In some examples, as shown in FIG. 4, multiple contact pads arranged in the first direction X are provided within the second signal access region B15, which may include, for example, multiple multiplexing control contact pads 721 and multiple first contact pads 722. The multiple multiplexing control contact pads 721 may be divided into a first set of multiplexing control contact pads 721a and a second set of multiplexing control contact pads 721b. The multiple first contact pads 722 may be located between the first set of multiplexing control contact pads 721a and the second set of multiplexing control contact pads 721b in the first direction X. For example, the first set of multiplexing control contact pads 721a may be located on a side of the multiple first contact pads 722 in an opposite direction of the first direction X, and the second set of multiplexing control contact pads 721b may be located on a side of the multiple first contact pads 722 in the first direction X. The multiple first contact pads 722 may be connected with multiple second side contact pads (multiple second side contact pads 714 shown in FIG. 5B) within the first signal access region B14 through multiple first pin connection lines 731.

In some examples, as shown in FIG. 4, the nine multiplexing control lines may be divided into two sets: a first set of multiplexing control lines (including, for example, the sixth multiplexing control line to the ninth reset control line) and a second set of multiplexing control lines (including, for example, the first multiplexing control line to the fifth multiplexing control line). The first set of multiplexing control lines may bypass a side surface of the first signal access region B14 from a side (e.g., a left side) of the first signal access region B14 in the opposite direction of the first direction X, access the first signal access region B14, and then lead out from a middle position of the first signal access region B14 to a side of the bending region B12. The second set of multiplexing control lines may bypass a side surface of the first signal access region B14 from a side (e.g., a right side) of the first signal access region B14 in the first direction X, access the first signal access region B14, and then lead out from the middle position of the first signal access region B14 to a side of the bending region B12. **In** this example, a grouping mode of the nine multiplexing control lines and a quantity of multiplexing control lines included in each group are not limited. In some other examples, the first set of multiplexing control lines may include five multiplexing control lines, and the second set of multiplexing control lines may include four multiplexing control lines. In some other examples, the first set of multiplexing control lines may include the seventh multiplexing control line to the ninth multiplexing control line and the fourth multiplexing control line, and the second set of multiplexing control lines may include the first multiplexing control line to the third multiplexing control line, the fifth multiplexing control line, and the sixth multiplexing control line.

In some examples, as shown in FIG. 4, each multiplexing control line may include a first sub-line, a second sub-line, and a third sub-line connected between the first sub-line and the second sub-line. For example, the first multiplexing control line may include a first sub-line 511, a third sub-line 513, and a second sub-line 512 connected sequentially. The second multiplexing control line may include a first sub-line 521, a third sub-line 523, and a second sub-line 522 connected sequentially. The third multiplexing control line may include a first sub-line 531, a third sub-line 533, and a second sub-line 532 connected sequentially. The fourth multiplexing control line may include a first sub-line 541, a third sub-line 543, and a second sub-line 542 connected sequentially. The fifth multiplexing control line may include a first sub-line 551, a third sub-line 553, and a second sub-line 552 connected sequentially. The sixth multiplexing control line may include a first sub-line 561, a third sub-line 563, and a second sub-line 562 connected sequentially. The seventh multiplexing control line may include a first sub-line 571, a third sub-line 573, and a second sub-line 572 connected sequentially. The eighth multiplexing control line may include a first sub-line 581, a third sub-line 583, and a second sub-line 582 connected sequentially. The ninth multiplexing control line may include a first sub-line 591, a third sub-line 593, and a second sub-line 592 connected sequentially.

In some examples, as shown in FIG. 4, the first sub-line 561 of the sixth multiplexing control line, the first sub-line 571 of the seventh multiplexing control line, the first sub-line 581 of the eighth multiplexing control line, and the first sub-line 591 of the ninth multiplexing control line may serve as a first set of first sub-lines 501a. The first sub-line 561 of the sixth multiplexing control line, the first sub-line 571 of the seventh multiplexing control line, the first sub-line 581 of the eighth multiplexing control line, and the first sub-line 591 of the ninth multiplexing control line within the first set of first sub-lines 501a may be sequentially arranged in a direction away from the first signal access region B14. In the present embodiment, an arrangement order of multiple first sub-lines within the first set of first sub-lines is not limited. In some other examples, the first sub-line 561 of the sixth multiplexing control line, the first sub-line 571 of the seventh multiplexing control line, the first sub-line 581 of the eighth multiplexing control line, and the first sub-line 591 of the ninth multiplexing control line within the first set of first sub-lines 501a may be sequentially arranged in a direction close to the first signal access region B14.

In some examples, the first set of first sub-lines 501a may be connected with the first set of multiplexing control contact pads 721a within the second signal access region B15. For example, each of the first sub-lines within the first set of first sub-lines 501a may be connected with at least one multiplexing control contact pad 721 within the first set of multiplexing control contact pads 721a.

In some examples, the first sub-line 511 of the first multiplexing control line, the first sub-line 521 of the second multiplexing control line, the first sub-line 531 of the third multiplexing control line, the first sub-line 541 of the fourth multiplexing control line, and the first sub-line 551 of the fifth multiplexing control line may serve as a second set of first sub-lines 501b. The first sub-line 511 of the first multiplexing control line, the first sub-line 521 of the second multiplexing control line, the first sub-line 531 of the third multiplexing control line, the first sub-line 541 of the fourth multiplexing control line, and the first sub-line 551 of the fifth multiplexing control line within the second set of first sub-lines 501b may be sequentially arranged in a direction away from the first signal access region B14. The present embodiment is not limited thereto.

In some examples, the second set of first sub-lines 501b may be connected with the second set of multiplexing control contact pads 721b within the second signal access region B15. For example, each of the first sub-lines within the second set of first sub-lines 501b may be connected with at least one multiplexing control contact pad 721 within the second set of multiplexing control contact pads 721b.

In some examples, second sub-lines of the nine multiplexing control lines may be located between the first set of multiplexing data lines 61a and the second set of multiplexing data lines 61b. The second sub-lines of the nine multiplexing control lines may be connected with multiple multiplexing control bending connection lines within the bending region B12. The second sub-line 562 of the sixth multiplexing control line, the second sub-line 572 of the seventh multiplexing control line, the second sub-line 582 of the eighth multiplexing control line, and the second sub-line 592 of the ninth multiplexing control line may serve as a first set of second sub-lines 502a. The second sub-line 512 of the first multiplexing control line, the second sub-line 522 of the second multiplexing control line, the second sub-line 532 of the third multiplexing control line, the second sub-line 542 of the fourth multiplexing control line, and the second sub-line 552 of the fifth multiplexing control line may serve as a second set of second sub-lines 502b. The second set of second sub-lines 502b may be located on a side of the first set of second sub-lines 502a in the first direction X.

**In** some examples, the second sub-line 562 of the sixth multiplexing control line, the second sub-line 572 of the seventh multiplexing control line, the second sub-line 582 of the eighth multiplexing control line, and the second sub-line 592 of the ninth multiplexing control line within the first set of second sub-lines 502a may be sequentially arranged in the opposite direction of the first direction X, and may all extend in the second direction Y. The second sub-line 512 of the first multiplexing control line, the second sub-line 522 of the second multiplexing control line, the second sub-line 532 of the third multiplexing control line, the second sub-line 542 of the fourth multiplexing control line, and the second sub-line 552 of the fifth multiplexing control line within the second set of second sub-lines 502b may be sequentially arranged in the first direction X, and may all extend in the second direction Y.

**In** some examples, third sub-lines of the nine multiplexing control lines may be located within the first signal access region B14. One end of each multiplexing control line may be connected with a first sub-line, and the other end may be connected with a second sub-line, such that the first sub-line and the second sub-line are electrically connected bypassing multiple multiplexing data lines 61.

In some examples, the third sub-line 563 of the sixth multiplexing control line, the third sub-line 573 of the seventh multiplexing control line, the third sub-line 583 of the eighth multiplexing control line, and the third sub-line 593 of the ninth multiplexing control line may serve as a first set of third sub-lines 503a. The third sub-line 563 of the sixth multiplexing control line, the third sub-line 573 of the seventh multiplexing control line, the third sub-line 583 of the eighth multiplexing control line, and the third sub-line 593 of the ninth multiplexing control line within the first set of third sub-lines 503a may be sequentially arranged in an opposite direction of the second direction Y.

In some examples, the third sub-line 513 of the first multiplexing control line, the third sub-line 523 of the second multiplexing control line, the third sub-line 533 of the third multiplexing control line, the third sub-line 543 of the fourth multiplexing control line, and the third sub-line 553 of the fifth multiplexing control line may serve as a second set of third sub-lines 503b. The third sub-line 513 of the first multiplexing control line, the third sub-line 523 of the second multiplexing control line, the third sub-line 533 of the third multiplexing control line, the third sub-line 543 of the fourth multiplexing control line, and the third sub-line 553 of the fifth multiplexing control line within the second set of third sub-lines 503b may be sequentially arranged in the opposite direction of the second direction Y.

In some examples, the first set of third sub-lines 503a and the second set of third sub-lines 503b may be arranged in the first direction X. An extension direction of each third sub-line may intersect with an extension direction of a second sub-line. For example, the third sub-line extends at least in the first direction X, and the second sub-line extends at least in the second direction Y.

In some examples, the first signal access region B14 may be provided with multiple first multiplexing adapter pads 711a and 711b, and multiple second multiplexing adapter pads 712a and 712b. The first signal access region B14 may have multiple sides. The multiple first multiplexing adapter pads 711a and 711b and the multiple second multiplexing adapter pads 712a and 712b may be arranged along a same side of the first signal access region B14, for example, along a side of the first signal access region B14 close to the bending region B12. The multiple second multiplexing adapter pads 712a and 712b may be located between multiple first multiplexing adapter pads 711a and multiple first multiplexing adapter pads 711b. The multiple first multiplexing adapter pads 711a and multiple second multiplexing adapter pads 712a may be located on two sides of multiple data contact pads (e.g., data contact pads 713a shown in FIG. 5B) with which the first set of multiplexing data lines 61a are connected. The multiple first multiplexing adapter pads 711b and multiple second multiplexing adapter pads 712b may be located on two sides of multiple data contact pads (e.g., data contact pads 713b shown in FIG. 5B) with which the second set of multiplexing data lines 61b are connected.

In some examples, the multiple first multiplexing adapter pads 711a may serve as a first set of first multiplexing adapter pads, and the first set of first multiplexing adapter pads may be connected with the first set of first sub-lines 501a and the first set of third sub-lines 503a. The multiple first multiplexing adapter pads 711b may serve as a second set of first multiplexing adapter pads, and the second set of first multiplexing adapter pads may be connected with the second set of first sub-lines 501b and the second set of third sub-lines 503b. For example, each of the first multiplexing adapter pads may be correspondingly connected with a first sub-line and a third sub-line.

In some examples, the multiple second multiplexing adapter pads 712a may serve as a first set of second multiplexing adapter pads, and the second set of second multiplexing adapter pads may be connected with the first set of third sub-lines 503a and the first set of second sub-lines 502a. The multiple second multiplexing adapter pads 712b may serve as a second set of second multiplexing adapter pads, and the second set of second multiplexing adapter pads may be connected with the second set of third sub-lines 503b and the second set of second sub-lines 502b. For example, each of the second multiplexing adapter pads may be correspondingly connected with a second sub-line and a third sub-line.

**In** this example, the multiple multiplexing control lines may avoid being overlapped with multiple multiplexing data lines by wiring in the first signal access region, and a coupling capacitance caused by overlapping between a multiplexing data line and a multiplexing control line may be eliminated. Moreover, second sub-lines of the multiple multiplexing control lines may be located between the first set of multiplexing data lines and the second set of multiplexing data lines, without being overlapped with or adjacent to the multiplexing data lines, and a certain interval distance is maintained from the multiplexing data lines, so that the coupling capacitance between the multiplexing control line and the multiplexing data line in three-dimensional space may be reduced, and display quality at extremely low gray scale may be guaranteed.

Next, a detailed structure of the first bezel region of the display panel of this example is illustrated through examples.

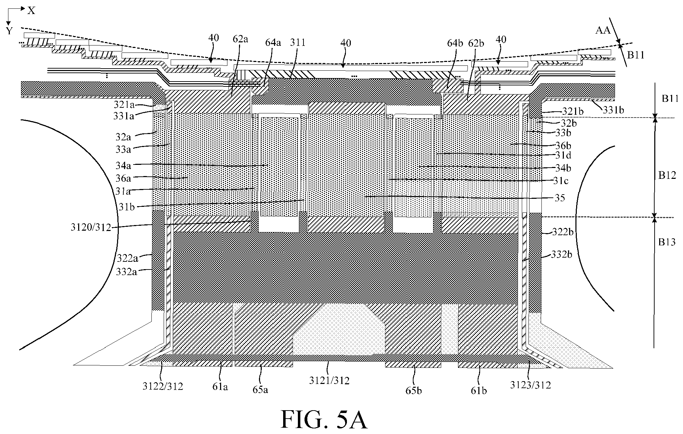

FIG. 5A is a schematic partial plan view of a first bezel region according to at least one embodiment of the present disclosure. FIG. 5A illustrates parts of the first fanout region B11, the bending region B12, and the second fanout region B13 of the first bezel region. **In** FIG. 5A, a panel detection line, a control leading-out line, a multiplexing data leading-out line, a data bending connection line, a touch bending connection line, a detection bending connection line, a control bending connection line, a multiplexing data line, and a panel detection leading-out line in the first bezel region are shown as a whole, and a quantity of various traces in the first bezel region is not limited in this example.

In some examples, as shown in FIG. 5A, the first fanout region B11 may be connected to the display region AA and the second bezel region. The first fanout region B11 may be provided with a first power supply line 311, a second power supply line 321a and 321b, multiple display leading-out lines, multiple panel detection lines (including a first set of panel detection lines 331a and a second set of panel detection lines 331b), and multiple multiplexing circuits 40.

In some examples, as shown in FIG. 5A, the first power supply line 311 may have a main body portion and a first extension portion (not shown in figures) extending along an edge of the display region AA, the main body portion of the first power supply line 311 may be substantially located at a midline position of the first fanout region B11 in the first direction X, and a midline of the first fanout region B11 in the first direction X may be parallel to the second direction Y. A shape of the main body portion of the first power supply line 311 may be substantially n-shaped and extend toward the bending region B12. The first extension portion of the first power supply line 311 may be electrically connected with multiple high potential power supply lines of the display region AA. For example, the first power supply line 311 may be located in the first source-drain metal layer, the high potential power supply lines of the display region may be located in the second source-drain metal layer, and the high potential power supply lines may extend to the first fanout region B11 and be connected with the first power supply line 311.

**In** some examples, as shown in FIG. 5A, the second power supply lines 321a and 321b may be located on two opposite sides of the first power supply line 311 in the first direction X. The second power supply line 321a may extend from a left side along an edge of the display panel towards the second bezel region, and the second power supply line 321b may extend from a right side along the edge of the display panel towards the second bezel region. The second power supply lines 321a and 321b may be connected in the second bezel region to provide a low potential power supply signal to multiple sub-pixels of the display region AA. In some examples, the first power supply lines 311, and the second power supply lines 321a and 321b may be of a same layer structure, for example, all may be located in the first source-drain metal layer. However, the present embodiment is not limited thereto. In some other examples, for the first power supply lines 311, and the second power supply lines 321a and 321b, a double-layer wiring structure of the first source-drain metal layer and the second source-drain metal layer may be adopted.

In some examples, as shown in FIG. 5A, a multiplexing circuit 40 may be configured to provide a data signal to multiple data lines using one signal source (e.g., connecting with one multiplexing data line). For example, multiple data lines (e.g., nine data lines) of the display region AA may extend to the first fanout region B11 and be connected with a same multiplexing circuit 40. A part of the multiplexing circuits 40 may be located on a side of the main body portion of the first power supply line 311 close to the display region AA, and arranged sequentially in the first direction X. Another part of the multiplexing circuits 40 may be arranged in a stepped manner along an edge of the display region AA.

In some examples, the first fanout region B11 may also be provided with multiple shift register units of the gate drive circuit, each of the shift register units may be connected with at least one gate line of the display region AA, configured to provide a gate drive signal to at least one gate line of the display region AA. For example, the shift register units may be located on a side of the multiplexing circuit away from the display region AA, or the shift register units may be arranged at intervals with the multiplexing circuits. The present embodiment is not limited thereto.

In some examples, as shown in FIG. 5A, the multiple display leading-out lines of the first fanout region B11 may at least include multiple control leading-out lines (e.g., including a first set of control leading-out lines 64a and a second set of control leading-out lines 64b), and multiple multiplexing data leading-out lines (e.g., including a first set of multiplexing data leading-out lines 62a and a second set of multiplexing data leading-out lines 62b).

In some examples, as shown in FIG. 5A, the multiple multiplexing data leading-out lines may be electrically connected with multiple multiplexing circuits 40. One multiplexing data leading-out line may be configured to transmit a data signal to a multiplexing circuit 40, so that the multiplexing circuit 40 supplies the data signal to multiple data lines connected with the multiplexing circuit 40. The multiple multiplexing data leading-out lines may, for example, be divided into a first set of multiplexing data leading-out lines 62a and a second set of multiplexing data leading-out lines 62b. Each set of multiplexing data leading-out lines may include multiple multiplexing data leading-out lines, and quantities of the two sets of multiplexing data leading-out lines may be the same or different. The first set of multiplexing data leading-out lines 62a and the second set of multiplexing data leading-out lines 62b may be located on two sides of the main body portion of the first power supply line 311 in the first direction X. For example, the first set of multiplexing data leading-out lines 62a may be located on a side of the main body portion of the first power supply line 311 in the opposite direction of the first direction X and extend to a left side. The second set of multiplexing data leading-out lines 62b may be located on a side of the main body portion of the first power supply line 311 in the first direction X and extend to a right side. Each set of multiplexing data leading-out lines may be divided into two parts, one part extending along an edge of the display region from a side of a control leading-out line close to the display region, and the other part extending along an edge of the display region from a side of the control leading-out line away from the display region. The multiple multiplexing data leading-out lines may be located on a side of the second power supply lines 331a and 331b close to the base substrate. The multiple multiplexing data leading-out lines may be of a same layer structure, for example, may all be located in the second gate metal layer.

In some examples, as shown in FIG. 5A, an orthographic projection of the multiple control leading-out lines on the base substrate may be overlapped with an orthographic projection of the main body portion of the first power supply line 311 on the base substrate. For example, the multiple control leading-out lines may be located in the second gate metal layer.

In some examples, as shown in FIG. 5A, the multiple control leading-out lines may be divided into a first set of control leading-out lines 64a and a second set of control leading-out lines 64b. Each set of control leading-out lines may include multiple control leading-out lines. A quantity of the first set of control leading-out lines 64a may be greater than or equal to a quantity of the second set of control leading-out lines 64b. The first set of control leading-out lines 64a and the second set of control leading-out lines 64b may be adjacent in the first direction X, the first set of control leading-out lines 64a may extend to the left side and the second set of control leading-out lines 64b may extend to the right side.

**In** some examples, the multiple control leading-out lines may include multiple multiplexing control leading-out lines and multiple drive control leading-out lines. For example, the multiple multiplexing control leading-out lines are connected with the multiple multiplexing circuits 40 and may be configured to provide multiplexing control signals to the multiple multiplexing circuits 40. The multiple drive control leading-out lines are connected with the gate drive circuit, for example, a drive control signal (e.g., including a start signal, a clock signal, a power supply signal, etc.) may be provided to the gate drive circuit.

**In** some examples, the multiple panel detection lines may be configured to perform crack detection of the display region AA. The multiple panel detection lines may be divided into a first set of panel detection lines 331a and a second set of panel detection lines 331b. An orthographic projection of the first set of panel detection lines 331a may be overlapped with an orthographic projection of the second power supply line 321a on the base substrate. An orthographic projection of the second set of panel detection lines 331b may be overlapped with an orthographic projection of the second power supply line 321b on the base substrate. For example, the multiple panel detection lines may be of a same layer structure, for example, all located in the second gate metal layer.

In some examples, as shown in FIG. 5A, the bending region B12 may be configured to enable the second fanout region B13, the first signal access region B14, and the second signal access region B15 to be bent to a back of the display region AA. The bending region B12 may be provided with multiple bending connection lines to connect traces in the first fanout region B11 and the second fanout region B13 that transmit a same signal. The multiple bending connection lines of the bending region B12 may be of a same layer structure, for example, may all be located in the second source-drain metal layer or the first source-drain metal layer.

In some examples, as shown in FIG. 5A, the multiple bending connection lines may include first power supply bending connection lines 31a, 31b, 31c, and 31d, second power supply bending connection lines 32a and 32b, a first set of detection bending connection lines 33a and a second set of detection bending connection lines 33b, a first set of touch bending connection lines 34a and a second set of touch bending connection lines 34b, a first set of data bending connection lines 36a and a second set of data bending connection lines 36b, and a set of control bending connection lines 35. The second power supply bending connection line 32a, the first set of detection bending connection lines 33a, the first set of data bending connection lines 36a, the first power supply bending connection line 31a, the first set of touch control bending connection lines 34a, the first power supply bending connection line 31b, the set of control bending connection lines 35, the first power supply bending connection line 31c, the second set of touch control bending connection lines 34b, the first power supply bending connection line 31d, the second set of data bending connection lines 36b, the second set of detection bending connection lines 33b, and the second power supply bending connection line 32b may be sequentially arranged in the first direction X. The set of control bending connection lines 35 may at least include multiple multiplexing control bending connection lines and multiple drive control bending connection lines. The multiple multiplexing control bending connection lines may be connected with the multiple multiplexing control connection lines of the second fanout region B13.

**In** this example, the first power supply bending connection line is arranged between the data bending connection line and the touch bending connection line, and the first power supply bending connection line is arranged between the control bending connection line and the touch bending connection line, which may be conducive to shielding mutual interference between the data bending connection line and the touch bending connection line, and the control bending connection line and the touch bending connection line.

FIG. 5B is a schematic partial plan view of a first bezel region according to at least one embodiment of the present disclosure. FIG. 5B illustrates structures of a part of the second fanout region B13, a part of the first signal access region B14, and a part of the second signal access region B15 of the first bezel region. FIG. 5B illustrates a wiring design of the multiple multiplexing control lines by taking the ninth multiplexing control line and the first multiplexing control line as an example. In FIG. 5B, the multiplexing data line, the control connection line, and a second control line segment of the control signal line in the first bezel region are shown as a whole. A first control line segment and a third control line segment of the control signal line are only exemplified by several traces. In this example, a quantity of various traces in the first bezel region is not limited.

In some examples, as shown in FIGs. 5A and 5B, the second fanout region B13 may be at least provided with a first power supply leading-out line 312, second power supply leading-out lines 322a and 322b, multiple panel detection leading-out lines (including a first set of panel detection leading-out lines 332a and a second set of panel detection leading-out lines 332b), multiple multiplexing data lines (including a first set of multiplexing data lines 61a and a second set of multiplexing data lines 61b), multiple control connection lines (including a first set of control connection lines 65a and a second set of control connection lines 65b), multiple control signal lines (including a first set of control signal lines 66a and a second set of control signal lines 66b), and multiple multiplexing control lines (including, for example, the ninth multiplexing control line 59 and the first multiplexing control line 51).

In some examples, as shown in FIG. 5A, the first power supply leading-out line 312 may include a first main body portion 3121 extending in the first direction X, four first connection portions 3120 connected with the first main body portion 3121, and a first extension portion 3122 and a second extension portion 3123 connected with the first main body portion 3121. The four first connection portions 3120 may be connected with a side of the first main body portion 3121 close to the bending region B12. The four first connection portions 3120 may be in a shape of a strip extending substantially in the second direction Y. The four first connection portions 3120 may be one-to-one correspondingly connected with the first power supply bending connection lines 31a, 31b, 31c, and 31d of the bending region B12. The first power supply leading-out line 312 may be connected with the first power supply line 311 within the first fanout region B11 through the four first power supply bending connection lines 31a, 31b, 31c, and 31d of the bending region B12. The first extension portion 3122 and the second extension portion 3123 may be connected with a side of the first main body portion 3121 away from the bending region B12. The first main body portion 3121, the four first connection portions 3120, the first extension portion 3122, and the second extension portion 3123 may be interconnected to form an integral structure. For example, the first power supply leading-out line 312 may be located in the first source-drain metal layer, or the first power supply leading-out line 312 may be of a double-layer wiring structure provided in the first source-drain metal layer and the second source-drain metal layer.

In some examples, as shown in FIG. 5B, the first extension portion 3122 of the first power supply leading-out line 312 may extend substantially in a third direction and then extend in the second direction Y toward the second signal access region B15. The second extension portion 3123 of the first power supply leading-out line 312 may extend substantially in a fourth direction and then extend in the second direction Y toward the second signal access region B15. The third direction intersects with both the first direction X and the second direction Y, the fourth direction intersects with both the first direction X and the second direction Y, and the third direction intersects with the fourth direction, for example, the third direction may be perpendicular to the fourth direction.

In some examples, as shown in FIGs. 5A and 5B, the second power supply leading-out line 322a may be located on a side of the first power supply leading-out line 312 in the opposite direction of the first direction X, and the second power supply leading-out line 322b may be located on a side of the first power supply leading-out line 312 in the first direction X. The second power supply leading-out line 322a may be connected with the second power supply line 321a through the second power supply connection line 32a of the bending region B12. The second power supply leading-out line 322b may be connected with the second power supply line 321b through the second power supply connection line 32b of the bending region B12. For example, the second power supply leading-out line 322a and the second power supply leading-out line 322b may be located in the first source-drain metal layer; or, the second power supply leading-out line 322a and the second power supply leading-out line 322b may be of a double-layer wiring structure provided in the first source-drain metal layer and the second source-drain metal layer.

**In** some examples, as shown in FIGs. 5A and 5B, the second power supply leading-out line 322a may extend in the second direction Y, the third direction, and the second direction Y sequentially, until access the second signal access region B15. The second power supply leading-out line 322b may extend in the second direction Y, the fourth direction, and the second direction Y sequentially, until access the second signal access region B15. The second power supply leading-out line 322a and the second power supply leading-out line 322b and the first power supply leading-out line 312 may be of a same layer structure.

**In** some examples, as shown in FIG. 5A, the multiple panel detection leading-out lines of the second fanout region B13 may be divided into a first set of panel detection leading-out lines 332a and a second set of panel detection leading-out lines 332b. The multiple panel detection leading-out lines of the first set of panel detection leading-out lines 332a may be connected with the multiple panel detection lines of the first set of panel detection lines 331a within the first fanout region B11 through the multiple detection bending connection lines of the first set of detection bending connection lines 33a of the bending region B12. The multiple panel detection leading-out lines within the second set of panel detection leading-out lines 332b may be connected with the multiple panel detection lines of the first set of panel detection lines 331b in the first fanout region B11 through the multiple detection bending connection lines of the second set of detection bending connection lines 33b of the bending region B12. The first set of panel detection leading-out lines 332a may be located on a side of the second power supply leading-out line 322a in the first direction X. The second set of panel detection leading-out lines 332b may be located on a side of the second power supply leading-out line 322b in the opposite direction of the first direction X. **In** some examples, the multiple panel detection leading-out lines may be of a same layer structure, for example, may all be located in the first gate metal layer.

**In** some examples, as shown in FIG. 5A, the multiple multiplexing data lines of the second fanout region B13 may extend substantially in the second direction Y towards the first signal access region B14. The multiple multiplexing data lines may be divided into a first set of multiplexing data lines 61a and a second set of multiplexing data lines 61b. Multiple multiplexing data lines of the first set of multiplexing data lines 61a may be connected with multiple multiplexing data leading-out lines of the first set of multiplexing data leading-out lines 62a in the first fanout region B11 through multiple data bending connection lines of the first set of data bending connection lines 36a of the bending region B12. Multiple multiplexing data lines of the second set of multiplexing data lines 61b may be connected with multiple multiplexing data leading-out lines of the second set of multiplexing data leading-out lines 62b in the first fanout region B11 through multiple data bending connection lines of the second set of data bending connection lines 36b of the bending region B12. For example, the first set of multiplexing data lines 61a may be configured to provide data signals to sub-pixels within a left half region of the display region AA, and the second set of multiplexing data lines 61b may be configured to provide data signals to sub-pixels within a right half region of the display region AA.

In some examples, as shown in FIGs. 5A and 5B, multiple control connection lines of the second fanout region B13 may extend in the second direction Y towards the first signal access region B14. The multiple control connection lines may include a first set of control connection lines 65a and a second set of control connection lines 65b. Multiple control connection lines of the first set of control connection lines 65a and the second set of control connection lines 65b may be connected with multiple control leading-out lines of the first set of control leading-out lines 64a and the second set of control leading-out lines 64b within the first fanout region B11 through multiple control bending connection lines within a set of control bending connection lines 35 of the bending region B12. The multiple control connection lines of this example may include multiple drive control connection lines and multiple multiplexing control connection lines. The multiple multiplexing control connection lines may be located in the middle of the multiple drive control connection lines.

In some examples, as shown in FIG. 5B, the multiple control signal lines of the second fanout region B13 may include a first set of control signal lines 66a and a second set of control signal lines 66b. The first set of control signal lines 66a may be connected with multiple drive control connection lines within the first set of control connection lines 65a. The second set of control signal lines 66b may be connected with multiple drive control connection lines within the second set of control connection lines 65b. The first set of control signal lines 66a may bypass the first signal access region B14 from one side (e.g., left side) in the first direction X and extend toward the second signal access region B15. The second set of control signal lines 66b may bypass the first signal access region B14 from the other side (e.g., right side) in the first direction X and extend toward the second signal access region B15.

In some examples, the multiple control signal lines of the second fanout region B13 may include multiple drive control lines. The multiple drive control lines may be connected with the multiple drive control leading-out lines of the first fanout region B11, and are configured to provide drive control signals (including, for example, a start signal, a clock signal, a voltage signal, etc.) to the gate drive circuit.

In some examples, as shown in FIG. 5B, at least one control signal line in the first set of control signal lines 66a may include a first control line segment 661a, a second control line segment 662a, and a third control line segment 663a connected sequentially. One end of the first control line segment 661a may be connected with a drive control connection line within the first set of control connection lines 65a, the other end of the first control line segment 661a may be connected with one end of the second control line segment 662a, the other end of the second control line segment 662a may be connected with one end of the third control line segment 663a, and the other end of the third control line segment 663a may access the second signal access region B15. At least one control signal line in the second set of control signal lines 66b may include a first control line segment 661b, a second control line segment 662b, and a third control line segment 663b connected sequentially. One end of the first control line segment 661b may be connected with a drive control connection line within the second set of control connection lines 65b, the other end of the first control line segment 661b may be connected with one end of the second control line segment 662b, the other end of the second control line segment 662b may be connected with one end of the third control line segment 663b, and the other end of the third control line segment 663b may access the second signal access region B15. **In** some examples, the third control line segment 663a and the third control line segment 663b, and the first control line segment 661a and the first control line segment 661b may be of a same layer structure, for example, located in the first source-drain metal layer, and the second control line segment 662a and the second control line segment 662b may be located in the second gate metal layer.

**In** some examples, an orthographic projection of the first control line segment 661a on the base substrate may be partially overlapped with an orthographic projection of the first set of multiplexing data lines 61a on the base substrate. An orthographic projection of the first control line segment 661b on the base substrate may be partially overlapped with an orthographic projection of the second set of multiplexing data lines 61b on the base substrate. The first control line segment 661a and the first control line segment 661b of the control signal line transmitting a same signal may be electrically connected through a connection line extending in the first direction X, the connection line may be located in the first source-drain metal layer, and an orthographic projection of the first set of multiplexing data lines 61a on the base substrate may be overlapped with an orthographic projection of the second set of multiplexing data lines 61a on the base substrate.

**In** some examples, a wiring mode of the multiple multiplexing control lines may be different from a wiring mode of the multiple control signal lines, so as to avoid overlapping between a multiplexing data line and a multiplexing control line to affect a display effect. A wiring mode of multiplexing control lines is illustrated by taking a case of the ninth multiplexing control line 59 and the first multiplexing control line 51 as an example.

In some examples, as shown in FIG. 5B, the second sub-line 592 of the ninth multiplexing control line 59 may be located on a side of the first control line segment 661a of the first set of control signal lines 66a away from the first set of multiplexing data lines 61a, and the second sub-line 592 may be connected with a multiplexing control connection line within the first set of control connection lines 65a. The second sub-line 592 may extend in the second direction Y to the first signal access region B14 and be connected with a second multiplexing adapter pad 712a within the first signal access region B14. The second multiplexing adapter pad 712a is connected with one end of the third sub-line 593 within the first signal access region B14. The third sub-line 593 may extend at least in the first direction X. The other end of the third sub-line 593 may be connected with one end of the first sub-line 591 through a first multiplexing adapter pad 711a. The first sub-line 591 may extend toward the second signal access region B15 across a first control line segment 661a of a part of control signal lines in the first set of control signal lines 66a. An orthographic projection of the first sub-line 591 on the base substrate may be overlapped with an orthographic projection of the first extension portion 3122 of the first power supply leading-out line 312 and the second power supply leading-out line 322a on the base substrate.

In some examples, as shown in FIG. 5B, the second sub-line 512 of the first multiplexing control line 51 may be located on a side of the first control line segment 661b of the second set of control signal lines 66b away from the second set of multiplexing data lines 61b, and the second sub-line 512 may be connected with a multiplexing control connection line within the second set of control connection lines 65b. The second sub-line 512 may extend in the second direction Y to the first signal access region B14 and be connected with a second multiplexing adapter pad 712b within the first signal access region B14. The second multiplexing adapter pad 712b is connected with one end of the third sub-line 513 within the first signal access region B14. The third sub-line 513 may extend at least in the first direction X. The other end of the third sub-line 513 may be connected with one end of the first sub-line 511 through a first multiplexing adapter pad 711b. The third sub-line 513 may be located on a side of the third sub-line 593 in the first direction X within the first signal access region B14. The first sub-line 511 may extend toward the second signal access region B15 across a first control line segment 661b of a part of control signal lines in the second set of control signal lines 66b. An orthographic projection of the first sub-line 511 on the base substrate may be overlapped with an orthographic projection of the second extension portion 3123 of the first power supply leading-out line 312 and the second power supply leading-out line 322b on the base substrate.

In some examples, the third sub-line 593 is located, for example, in the first gate metal layer. The first sub-line 591 may include a first line segment, a second line segment, a third line segment, and a fourth line segment connected sequentially. The first line segment may be connected with a multiplexing control contact pad 721 in the second signal access region B15 and the fourth line segment may be connected with a first multiplexing adapter pad 711a in the first signal access region B14. An orthographic projection of the second line segment may be overlapped with an orthographic projection of the first power supply leading-out line 312 and the second power supply leading-out line 322a on the base substrate. An orthographic projection of the fourth line segment may be overlapped with an orthographic projection of a first control line segment 661a of a part of control signal lines of the first set of control signal lines 66a on the base substrate. The first line segment and the third line segment may be located, for example, in the first source-drain metal layer, the second line segment may be located, for example, in the second gate metal layer, and the fourth line segment may be located, for example, in the first gate metal layer. The first multiplexing adapter pad 711a may be, for example, of a double-layer pin structure provided in the first gate metal layer and the first source-drain metal layer. The second sub-line 592 may include a fifth line segment and a sixth line segment connected sequentially, the fifth line segment may be connected with a second multiplexing adapter pad 712a in the first signal access region B14, and the sixth line segment may be connected with a multiplexing control connection line within the first set of control connection lines 65a. The fifth line segment may be located, for example, in the first gate metal layer and the sixth line segment may be located, for example, in the first source-drain metal layer. The second multiplexing adapter pad 712a may be, for example, of a double-layer pin structure provided in the first gate metal layer and the first source-drain metal layer.

In some examples, the fourth line segment of the first sub-line 591 of the ninth multiplexing control line, a part of the first multiplexing adapter pad 711a located in the first gate metal layer, the third sub-line 593, a part of the second multiplexing adapter pad 712a located in the first gate metal layer, and the fifth line segment of the second sub-line 592 may be interconnected to form an integral structure, for example, located in the first gate metal layer. A multiplexing control connection line with which the sixth line segment of the second sub-line 592 of the ninth multiplexing control line is connected may be located in the second gate metal layer. The present embodiment is not limited thereto. In some other examples, the sixth line segment of the second sub-line 592 of the ninth multiplexing control line and the connected multiplexing control connection line may be interconnected to form an integral structure, for example, located in the second gate metal layer.

A wiring mode of rest multiplexing control lines and a film layer arrangement may be referred to description of the ninth multiplexing control line, thus will not be described herein in detail.

In some examples, as shown in FIG. 5B, the first signal access region B14 may be configured to provide a drive chip (Integrated Circuit (IC)), for example, the drive chip provided in the first signal access region B14 may be a display drive chip or may be a Touch and Display Driver Integration chip (TDDI). The first signal access region B14 may also be referred to as a drive chip setting region. The drive chip may be configured to generate a data signal required for driving sub-pixels.

In some examples, as shown in FIG. 5B, the first signal access region B14 may be substantially rectangular. The first signal access region B14 may have a first side close to the bending region B12, a second side away from the bending region B12, and a third side and a fourth side connected between the first side and the second side. The fourth side may be located on a side of the third side in the first direction X. The first side and the second side may extend, for example, in the first direction X, and the third side and the fourth side may extend, for example, in the second direction Y.

In some examples, the first signal access region B14 may be provided with multiple first side contact pads, multiple second side contact pads 714, multiple third side contact pads 715, and multiple fourth side contact pads 716. The multiple first side contact pads may be sequentially arranged along an extension direction of the first side (e.g., the first direction X), and may at least include a first set of multiplexing adapter pads (including multiple first multiplexing adapter pads 711a), a second set of multiplexing adapter pads (including multiple first multiplexing adapter pads 711b), multiple second multiplexing adapter pads 712a and 712b, a first set of data contact pads (including multiple data contact pads 713a), and a second set of data contact pads (including multiple data contact pads 713b). The multiple data contact pads 713a and 713b may be configured to receive data signals from the drive chip. The multiple data contact pads 713a may be located between the multiple first multiplexing adapter pads 711a and the multiple second multiplexing adapter pads 712a, and connected with the first set of multiplexing data lines 61a. The multiple data contact pads 713b may be located between the multiple second multiplexing adapter pads 712b and the multiple first multiplexing adapter pads 711b, and connected with the second set of multiplexing data lines 61b. The multiple second multiplexing adapter pads 712a and 712b may be located in the middle of the multiple data contact pads 713a and 713b. Contact pads connected with multiple touch adapter lines 74 may be provided between the multiple second multiplexing adapter pads 712a and the multiple second multiplexing adapter pads 712b, and the multiple touch adapter lines 74 may be configured to be connected with touch lead lines of the touch structure layer to transmit touch signals.

In some examples, the multiple second side contact pads 714 may be sequentially arranged along an extension direction of the second side (e.g., the first direction X). The multiple third side contact pads 715 may be sequentially arranged, for example, misaligned, along an extension direction of the third side (for example, the second direction Y). The multiple fourth side contact pads 716 may be sequentially arranged, for example, misaligned, along the extension direction of the fourth side (for example, the second direction Y).

In some examples, as shown in FIG. 5B, the second signal access region B15 may be provided with multiple contact pads, and the multiple contact pads may be configured to bond a Flexible Printed Circuit (FPC), such that multiple signal lines (e.g., a control signal line, a power supply line, etc.) are connected with an external control apparatus through the multiple contact pads. The second signal access region B15 may also be referred to as a circuit bonding region.

In some examples, the multiple contact pads of the second signal access region B15 may include multiple first contact pads 722, multiple second contact pads (including a first set of second contact pads 723a and a second set of second contact pads 723b), multiple DC signal contact pads (including a first set of DC signal contact pads 724a and a second set of DC signal contact pads 724b), multiple square wave signal contact pads 725, and multiple multiplexing control contact pads 721.

In some examples, the multiple contact pads of the second signal access region B15 may be arranged in the first direction X. The multiple first contact pads 722 may be located between a first set of second contact pads 723a and a second set of second contact pads 723b. The multiple first contact pads 722 may be connected with the multiple second side contact pads 714 within the first signal access region B14 through the multiple first pin connection lines 731. The first set of second contact pads 723a may be connected with the multiple third side contact pads 715 within the first signal access region B14 through the multiple second pin connection lines 732. The second set of second contact pads 723b may be connected with the multiple fourth side contact pads 716 within the first signal access region B14 through the multiple third pin connection lines 733.

In some examples, the first set of DC signal contact pads 724a may be located on a side of the first set of second contact pads 723a away from the multiple first contact pads 722, and the second set of DC signal contact pads 724a may be located on a side of the second set of second contact pads 723b away from the multiple first contact pads 722. Each set of DC signal contact pads may include at least one first voltage contact pad 7241 and at least one second voltage contact pad 7242. Within each set of DC signal contact pads, the first voltage contact pad 7241 may be located on a side of the second voltage contact pad 7242 close to the first signal access region B14. The first voltage contact pad 7241 may be configured to be connected with the first power supply leading-out line 312 and the second voltage contact pad 7241 may be configured to be connected with the second power supply leading-out line 322a or the second power supply leading-out line 322b.

In some examples, the multiple square wave signal contact pads 725 may be located on a side of the multiple DC signal contact pads away from the first signal access region B14, for example, on a side of the multiple DC signal contact pads close to an edge of the display panel in the first direction X. The multiple multiplexing control contact pads 721 may be located in the middle of the multiple square wave signal contact pads 725 and adjacent to a square wave signal contact pad 725. For example, multiple square wave signal contact pads 725 may be provided between a multiplexing control contact pad 721 and a DC signal contact pad, and multiple square wave signal contact pads 725 may be provided on a side of the multiplexing control contact pad 721 away from the DC signal contact pad.

In some examples, the first set of control signal lines 66a and the second set of control signal lines 66b may be connected with multiple square wave signal contact pads 725 within the second signal access region B15. First sub-lines of multiple multiplexing control lines may be connected with multiple multiplexing control contact pads 721 within the second signal access region B15.

In this example, since the multiplexing control contact pad 721 of the second signal access region B15 is located outside the DC signal contact pad, and multiple square wave signal contact pads 725 are provided between the multiplexing control contact pad and the DC signal contact pad, after a first sub-line of a multiplexing control line is connected with a multiplexing control contact pad, the first sub-line crosses multiple control signal lines connected with a square wave signal contact pad 725, and accesses the first signal access region B14, and is connected with a third sub-line to bypass a multiplexing data line. This example may eliminate a situation that a display effect is poor due to overlapping between e multiple multiplexing data lines and multiple multiplexing control lines, thereby improving the display effect.

Wiring of signal transmission within the first bezel region of this example may be shown in Table 1. A data signal may be provided by a data contact pad within the first signal access region B14, and a drive control signal, a first power supply signal, a second power supply signal, and a multiplexing control signal (including, for example, a first multiplexing control signal to a ninth multiplexing control signal) may be provided by a contact pad within the second signal access region B15.

**Table 1**

| | Second fanout region | Bending region | First fanout region |
|---|---|---|---|
| Data signal | First set of multiplexing data lines 61a and second set of multiplexing data lines 61b | First set of data bending connection lines 36a and second set of data bending connection lines 36b | First set of multiplexing data leading-out lines 62a and second set of multiplexing data leading-out lines 62b are connected to a multiplexing circuit 40, and then are transmitted to sub-pixels of the display region through multiple data lines |
| Drive control signal | First set of control signal lines 66a are connected with drive control connection lines within the first set of control connection lines 65a, second set of control signal lines 66b are connected with drive control connection lines within the second set of control connection lines 65b | Drive control bending connection lines within a set of control bending connection line 35 | Multiple drive control leading-out lines within a first set of control leading-out lines 64a and a second set of control leading-out lines 64b |
| First power supply signal | First power supply leading-out line 312 | First power supply bending connection lines 31a, 31b, 31c, and 31d | First power supply line 311 |
| Second power supply signal | Second power supply leading-out lines 322a and 322b | Second power supply bending connection lines 32a and 32b | Second power supply lines 321a and 321b |
| Multiplexing control signal | First set of multiplexing control lines (including four multiplexing control lines) are connected with multiplexing control connection lines within the first set of control connection lines 65a; second set of multiplexing control lines (including five multiplexing control lines) are connected with multiplexing control connection lines within the second set of control connection lines 65b | Multiplexing control bending connection lines within a set of control bending connection lines 35 | Multiple multiplexing control leading-out lines within the first set of control leading-out lines 64a and the second set of control leading-out lines 64b |

A wiring mode of multiplexing control lines of this example may avoid being overlapped with multiple multiplexing data lines, and eliminate a coupling capacitance caused by overlapping between a multiplexing data line and a multiplexing control line. Moreover, a second sub-line of the multiplexing control line is located between the first set of multiplexing data lines and the second set of multiplexing data lines, and maintains a certain distance from the multiplexing data line (a part of the second sub-line is not adjacent to the multiplexing data line), so that the coupling capacitance of the multiplexing data line and the multiplexing control line in the three-dimensional space is reduced, thereby improving a display effect and ensuring e display quality under extremely low gray scale.

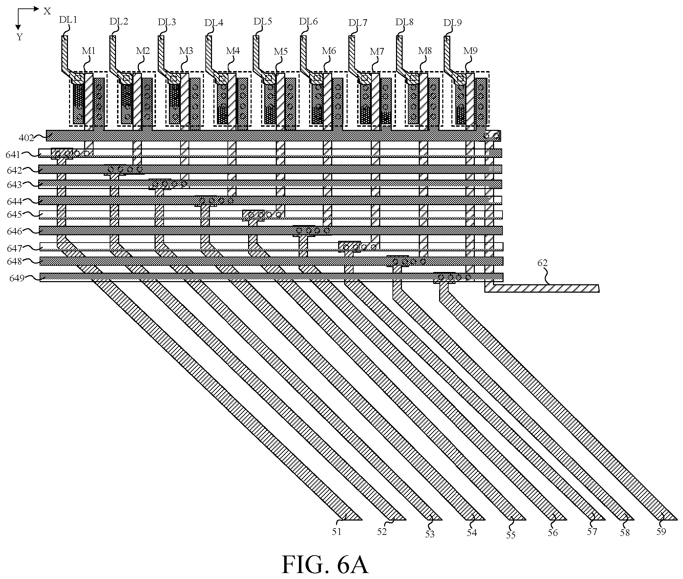

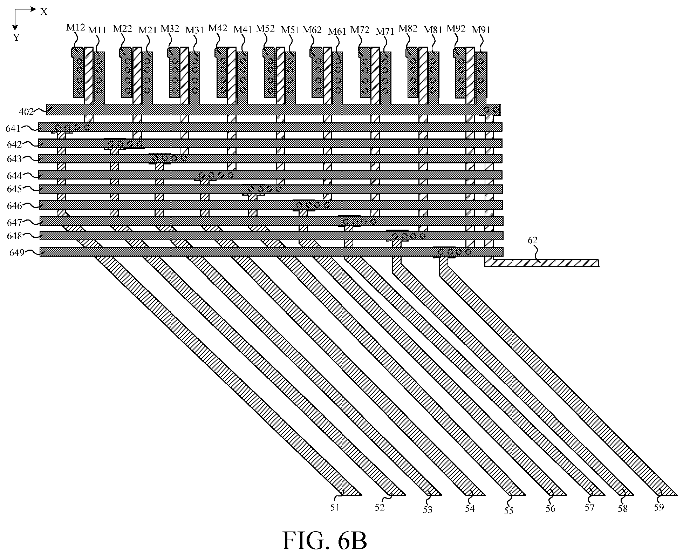

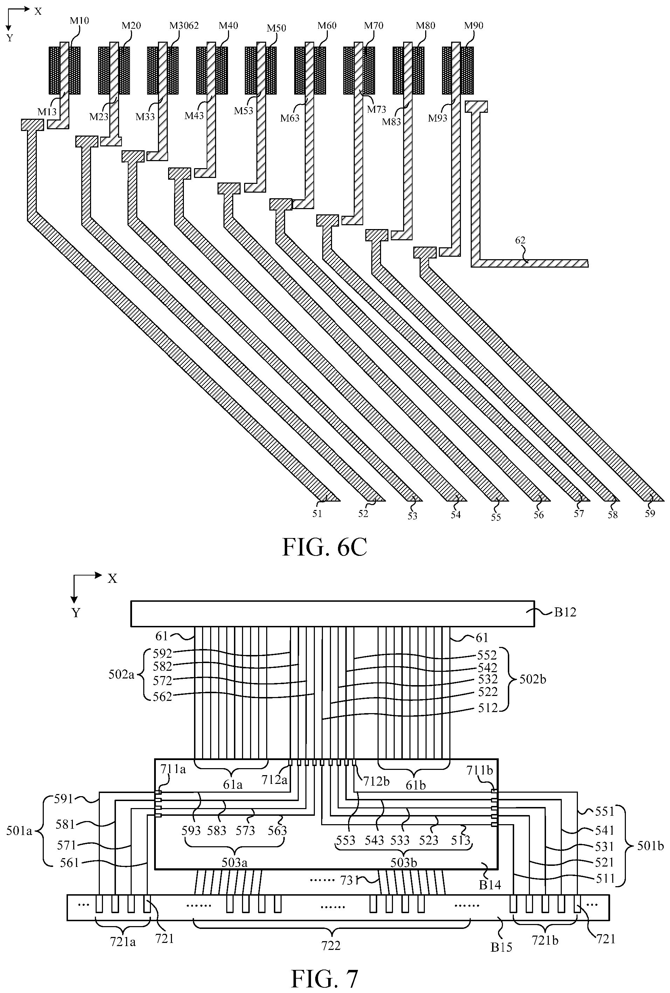

FIG. 6A is a schematic top view of a multiplexing circuit according to at least one embodiment of the present disclosure. FIG. 6B is a schematic diagram of the multiplexing circuit after forming a first source-drain metal layer in FIG. 6A. FIG. 6C is a schematic diagram of the multiplexing circuit after forming a second gate metal layer in FIG. 6A. A schematic top view of a multiplexing circuit for which a 1:9 design is adopted is shown in FIG. 6A.

In some examples, as shown in FIGs. 6A to 6C, active layers of nine multiplexing transistors of the multiplexing circuit may be located in the semiconductor layer. An active layer of each multiplexing transistor may include a first region, a second region, and a channel region located between the first region and the second region. A first active layer M10 of a first multiplexing transistor M1, a second active layer M20 of a second multiplexing transistor M2, a third active layer M30 of a third multiplexing transistor M3, a fourth active layer M40 of a fourth multiplexing transistor M4, a fifth active layer M50 of a fifth multiplexing transistor M5, a sixth active layer M60 of a sixth multiplexing transistor M6, a seventh active layer M70 of a seventh multiplexing transistor M7, an eighth active layer M80 of an eighth multiplexing transistor M8, and a ninth active layer M90 of a ninth multiplexing transistor M9 may be sequentially arranged in the first direction X. An orthographic projection of the active layers of the nine multiplexing transistors on the base substrate may be approximately rectangular.

In some examples, gates of the nine multiplexing transistors of the multiplexing circuit may be located in the first gate metal layer. An orthographic projection of a gate of each multiplexing transistor on the base substrate may cover an orthographic projection of a channel region of a corresponding active layer on the base substrate. A gate M13 of the first multiplexing transistor M1, a gate M23 of the second multiplexing transistor M2, a gate M33 of the third multiplexing transistor M3, a gate M43 of the fourth multiplexing transistor M4, a gate M53 of the fifth multiplexing transistor M5, a gate M63 of the sixth multiplexing transistor M6, a gate M73 of the seventh multiplexing transistor M7, a gate M83 of the eighth multiplexing transistor M8, and a gate M93 of the ninth multiplexing transistor M9 may all extend in the second direction Y and be sequentially arranged in the first direction X. Lengths of the gate M13 of the first multiplexing transistor M1, the gate M23 of the second multiplexing transistor M2, the gate M33 of the third multiplexing transistor M3, the gate M43 of the fourth multiplexing transistor M4, the gate M53 of the fifth multiplexing transistor M5, the gate M63 of the sixth multiplexing transistor M6, the gate M73 of the seventh multiplexing transistor M7, the gate M83 of the eighth multiplexing transistor M8, and the gate M93 of the ninth multiplexing transistor M9 may be successively increased in the second direction Y.

In some examples, first electrodes and second electrodes of the nine multiplexing transistors of the multiplexing circuit may be located in the first source-drain metal layer. A first electrode M11 of the first multiplexing transistor M1 may be connected with a first region of the first active layer M10 of the first multiplexing transistor M1 through multiple (four) vias opened in the interlayer dielectric layer, the second gate insulation layer, and the first gate insulation layer. A first electrode M21 of the second multiplexing transistor M2 may be connected with a first region of the second active layer M20 of the second multiplexing transistor M2 through multiple (four) vias opened in the interlayer dielectric layer, the second gate insulation layer, and the first gate insulation layer. A first electrode M31 of the third multiplexing transistor M3 may be connected with a first region of the third active layer M30 of the third multiplexing transistor M3 through multiple (four) vias opened in the interlayer dielectric layer, the second gate insulation layer, and the first gate insulation layer. A first electrode M41 of the fourth multiplexing transistor M4 may be connected with a first region of the fourth active layer M40 of the fourth multiplexing transistor M4 through multiple (four) vias opened in the interlayer dielectric layer, the second gate insulation layer, and the first gate insulation layer. A first electrode M51 of the fifth multiplexing transistor M5 may be connected with a first region of the fifth active layer M50 of the fifth multiplexing transistor M5 through multiple (four) vias opened in the interlayer dielectric layer, the second gate insulation layer, and the first gate insulation layer. A first electrode M61 of the sixth multiplexing transistor M6 may be connected with a first region of the sixth active layer M60 of the sixth multiplexing transistor M6 through multiple (four) vias opened in the interlayer dielectric layer, the second gate insulation layer, and the first gate insulation layer. A first electrode M71 of the seventh multiplexing transistor M7 may be connected with a first region of the seventh active layer M70 of the seventh multiplexing transistor M7 through multiple (four) vias opened in the interlayer dielectric layer, the second gate insulation layer, and the first gate insulation layer. A first electrode M81 of the eighth multiplexing transistor M8 may be connected with a first region of the eighth active layer M80 of the eighth multiplexing transistor M8 through multiple (four) vias opened in the interlayer dielectric layer, the second gate insulation layer, and the first gate insulation layer. A first electrode M91 of the ninth multiplexing transistor M9 may be connected with a first region of the ninth active layer M90 of the ninth multiplexing transistor M9 through multiple (four) vias opened in the interlayer dielectric layer, the second gate insulation layer, and the first gate insulation layer.

In some examples, the first electrode M11 of the first multiplexing transistor M1, the first electrode M21 of the second multiplexing transistor M2, the first electrode M31 of the third multiplexing transistor M3, the first electrode M41 of the fourth multiplexing transistor M4, the first electrode M51 of the fifth multiplexing transistor M5, the first electrode M61 of the sixth multiplexing transistor M6, the first electrode M71 of the seventh multiplexing transistor M7, the first electrode M81 of the eighth multiplexing transistor M8, and the first electrode M91 of the ninth multiplexing transistor M9 are connected with a first auxiliary line 402. The first electrodes of the nine multiplexing transistors and the first auxiliary line 402 may be interconnected to form an integral structure. The first auxiliary line 402 is in a shape of a line extending in the first direction X. The first auxiliary line 402 may be connected with a multiplexing data leading-out line 62 located in the first gate metal layer through a via opened in the interlayer dielectric layer and the second gate insulation layer. Multiplexing data leading-out lines connected with adjacent multiplexing circuits may be located in different conductive layers. For example, the multiple multiplexing data leading-out lines may be arranged at intervals in the first gate metal layer and the second gate metal layer.

In some examples, a second electrode M12 of the first multiplexing transistor M1 may be connected with a second region of the first active layer M10 of the first multiplexing transistor M1 through multiple (four) vias opened in the interlayer dielectric layer, the second gate insulation layer, and the first gate insulation layer. A second electrode M22 of the second multiplexing transistor M2 may be connected with a second region of the second active layer M20 of the second multiplexing transistor M2 through multiple (four) vias opened in the interlayer dielectric layer, the second gate insulation layer, and the first gate insulation layer. A second electrode M32 of the third multiplexing transistor M3 may be connected with a second region of the third active layer M30 of the third multiplexing transistor M3 through multiple (four) vias opened in the interlayer dielectric layer, the second gate insulation layer, and the first gate insulation layer. A second electrode M42 of the fourth multiplexing transistor M4 may be connected with a second region of the fourth active layer M40 of the fourth multiplexing transistor M4 through multiple (four) vias opened in the interlayer dielectric layer, the second gate insulation layer, and the first gate insulation layer. A second electrode M52 of the fifth multiplexing transistor M5 may be connected with a second region of the fifth active layer M50 of the fifth multiplexing transistor M5 through multiple (four) vias opened in the interlayer dielectric layer, the second gate insulation layer, and the first gate insulation layer. A second electrode M62 of the sixth multiplexing transistor M6 may be connected with a second region of the sixth active layer M60 of the sixth multiplexing transistor M6 through multiple (four) vias opened in the interlayer dielectric layer, the second gate insulation layer, and the first gate insulation layer. A second electrode M72 of the seventh multiplexing transistor M7 may be connected with a second region of the seventh active layer M70 of the seventh multiplexing transistor M7 through multiple (four) vias opened in the interlayer dielectric layer, the second gate insulation layer, and the first gate insulation layer. A second electrode M82 of the eighth multiplexing transistor M8 may be connected with a second region of the eighth active layer M80 of the eighth multiplexing transistor M8 through multiple (four) vias opened in the interlayer dielectric layer, the second gate insulation layer, and the first gate insulation layer. A second electrode M92 of the ninth multiplexing transistor M9 may be connected with a second region of the ninth active layer M90 of the ninth multiplexing transistor M9 through multiple (four) vias opened in the interlayer dielectric layer, the second gate insulation layer, and the first gate insulation layer.

In some examples, data lines DL1 to DL9 may be located in the second source-drain metal layer. A data line DL1 may be connected with the second electrode M12 of the first multiplexing transistor M1 through a via opened in the first planarization layer and the passivation layer. A data line DL2 may be connected with the second electrode M22 of the second multiplexing transistor M2 through a via opened in the first planarization layer and the passivation layer. A data line DL3 may be connected with the second electrode M32 of the third multiplexing transistor M3 through a via opened in the first planarization layer and the passivation layer. A data line DL4 may be connected with the second electrode M42 of the fourth multiplexing transistor M4 through a via opened in the first planarization layer and the passivation layer. A data line DL5 may be connected with the second electrode M52 of the fifth multiplexing transistor M5 through a via opened in the first planarization layer and the passivation layer. A data line DL6 may be connected with the second electrode M62 of the sixth multiplexing transistor M6 through a via opened in the first planarization layer and the passivation layer. A data line DL7 may be connected with the second electrode M72 of the seventh multiplexing transistor M7 through a via opened in the first planarization layer and the passivation layer. A data line DL8 may be connected with the second electrode M82 of the eighth multiplexing transistor M8 through a via opened in the first planarization layer and the passivation layer. A data line DL9 may be connected with the second electrode M92 of the ninth multiplexing transistor M9 through a via opened in the first planarization layer and the passivation layer.

In some examples, illustration is made by taking a case in which a multiplexing control leading-out line is directly connected with a multiplexing control line as an example. Multiple multiplexing control leading-out lines (e.g., a first multiplexing control leading-out line 641 to a ninth multiplexing control leading-out line 649) may be located in the first source-drain metal layer. The multiple multiplexing control leading-out lines may extend at least in the first direction X and be sequentially arranged in the second direction Y. Multiple multiplexing control lines (e.g., a first multiplexing control line 51 to a ninth multiplexing control line 59) may be located at least in the second gate metal layer. The multiple multiplexing control lines may extend at least in the second direction Y and be arranged in the first direction X.

In some examples, the first multiplexing control leading-out line 641 may be connected with the gate M13 of the first multiplexing transistor M1 and the first multiplexing control line 51, and configured to transmit a first multiplexing control signal. The second multiplexing control leading-out line 642 may be connected with the gate M23 of the second multiplexing transistor M2 and the second multiplexing control line 52, and configured to transmit a second multiplexing control signal. The third multiplexing control leading-out line 643 may be connected with the gate M33 of the third multiplexing transistor M3 and the third multiplexing control line 53, and configured to transmit a third multiplexing control signal. The fourth multiplexing control leading-out line 644 may be connected with the gate M43 of the fourth multiplexing transistor M4 and the fourth multiplexing control line 54, and configured to transmit a fourth multiplexing control signal. The fifth multiplexing control leading-out line 645 may be connected with the gate M53 of the fifth multiplexing transistor M5 and the fifth multiplexing control line 55, and configured to transmit a fifth multiplexing control signal. The sixth multiplexing control leading-out line 646 may be connected with the gate M63 of the sixth multiplexing transistor M6 and the sixth multiplexing control line 56, and configured to transmit a sixth multiplexing control signal. The seventh multiplexing control leading-out line 647 may be connected with the gate M73 of the seventh multiplexing transistor M7 and the seventh multiplexing control line 57, and configured to transmit a seventh multiplexing control signal. The eighth multiplexing control leading-out line 648 may be connected with the gate M83 of the eighth multiplexing transistor M8 and the eighth multiplexing control line 58, and configured to transmit an eighth multiplexing control signal. The ninth multiplexing control leading-out line 649 may be connected with the gate M93 of the ninth multiplexing transistor M9 and the ninth multiplexing control line 59, and configured to transmit a ninth multiplexing control signal. An arrangement mode of this example is conducive to a reasonable arrangement of multiplexing circuits in the first fanout region.

FIG. 7 is an exemplary diagram of another arrangement of a multiplexing control line and a multiplexing data line according to at least one embodiment of the present disclosure. FIG. 7 is illustrated by taking a case of only several multiplexing data lines as an example. FIG. 7 is a schematic diagram showing a general trend of a multiplexing control line and a multiplexing data line in a second fanout region of a display panel. In this embodiment, a quantity of multiplexing data lines is not limited. This example is illustrated by taking a case in which a 1:9 design shown in FIG. 3 is adopted for a multiplexing circuit as an example.

In some examples, as shown in FIG. 7, within the first signal access region B14, the multiple first multiplexing adapter pads 711a may be arranged in an extension direction of the third side (e.g., the second direction Y), the multiple first multiplexing adapter pads 711b may be arranged in an extension direction of the fourth side (e.g., the second direction Y), and the multiple second multiplexing adapter pads 712a and 712b may be arranged in an extension direction of the first side (e.g., the first direction X). An arrangement direction of the multiple first multiplexing adapter pads is different from an arrangement direction of the multiple second multiplexing adapter pads. In some examples, the multiple first multiplexing adapter pads 711a may be located on a side of the third side contact pad 715 close to the first side, and the multiple first multiplexing adapter pads 711b may be located on a side of the fourth side contact pad 716 close to the first side. In some examples, within the second signal access region B14, the multiplexing control contact pad 721 may be disposed between the DC signal contact pad and the second contact pad, and overlap between the first sub-line of the multiplexing control line and the control signal line may be reduced. However, the present embodiment is not limited thereto.

Rest of description of the display panel of the example may be referred to description of the aforementioned embodiments, and thus will not be repeated herein.

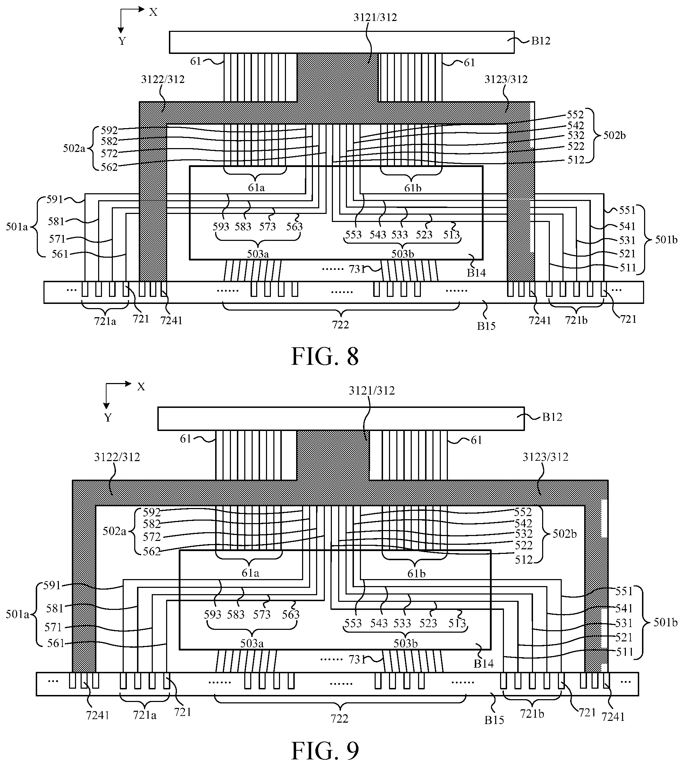

FIG. 8 is an exemplary diagram of another arrangement of a multiplexing control line and a multiplexing data line according to at least one embodiment of the present disclosure. FIG. 8 is illustrated by taking a case of only several multiplexing data lines as an example. FIG. 8 is a schematic diagram showing a general trend of a multiplexing control line, a multiplexing data line, and a first power supply leading-out line in the second fanout region of the display panel. In this embodiment, a quantity of multiplexing data lines is not limited. This example is illustrated by taking a case in which a 1:9 design shown in FIG. 3 is adopted for a multiplexing circuit as an example.

In some examples, as shown in FIG. 8, the first extension portion 3122 of the first power supply leading-out line 312 of the second fanout region may be connected with at least one first voltage contact pad 7241 within the first set of DC signal contact pads within the second signal access region B15, and the second extension portion 3123 may be connected with at least one first voltage contact pad 7241 within the second set of DC signal contact pads within the second signal access region B15. The first set of DC signal contact pads may be located inside the first set of multiplexing control contact pads 721a and the second set of DC signal contact pads may be located inside the second set of multiplexing control contact pads 721b. For example, a square wave signal contact pad may not be provided between the first set of DC signal contact pads and the first set of multiplexing control contact pads 721a, and a square wave signal contact pad may not be provided between the second set of DC signal contact pads and the second set of multiplexing control contact pads 721b.

In some examples, an orthographic projection of the first sub-line of the first set of multiplexing control lines (e.g., the first sub-line 591 of the ninth multiplexing control line) on the base substrate may be overlapped with an orthographic projection of the first extension portion 3122 of the first power supply leading-out line 312 on the base substrate. An orthographic projection of the first sub-line of the second set of multiplexing control lines (e.g., the first sub-line 511 of the first multiplexing control line) on the base substrate may be overlapped with an orthographic projection of the second extension portion 3123 of the first power supply leading-out line 312 on the base substrate. An orthographic projection of first sub-lines of the multiplexing control lines on the base substrate may be not overlapped with an orthographic projection of the square wave signal transmission lines (including, for example, multiple control signal lines) on the base substrate.

In some examples, within the second signal access region B15, the second voltage contact pad is located inside the multiplexing control contact pad 721, and then an orthographic projection of the first sub-line of the multiplexing control line on the base substrate is overlapped with an orthographic projection of the second power supply leading-out line on the base substrate. Within the second signal access region B15, the second voltage contact pad is located outside the multiplexing control contact pad 721, and then an orthographic projection of the first sub-line of the multiplexing control line on the base substrate may not be overlapped with an orthographic projection of the second power supply leading-out line on the base substrate.

In the display panel of this example, after being connected with the multiplexing control contact pad 721, the first sub-line of the multiplexing control line extends toward a side close to the bending region B12, and only needs to cross the DC signal transmission line (such as the first power supply leading-out line, or the first power supply leading-out line and the second power supply leading-out line), and is connected with the third sub-line in the first signal access region B14. The third sub-line is led out and connected with the second sub-line at a middle position of the first signal access region B14, so that bypassing the multiplexing data line is achieved and overlap between the multiplexing control line and the multiplexing data line is avoided. This example reduces overlap between the multiplexing control line and rest square wave signal transmission lines, and may avoid the multiplexing control signal from being crosstalk, thereby avoiding poor split screen at a low gray scale. Rest of description of the display panel of the example may be referred to description of the aforementioned embodiments, and thus will not be repeated herein.

FIG. 9 is an exemplary diagram of another arrangement of a multiplexing control line and a multiplexing data line according to at least one embodiment of the present disclosure. FIG. 8 is illustrated by taking a case of only several multiplexing data lines as an example. FIG. 9 is a schematic diagram showing a general trend of a multiplexing control line, a multiplexing data line, and a first power supply leading-out line in the second fanout region of the display panel. In this embodiment, a quantity of multiplexing data lines is not limited. This example is illustrated by taking a case in which a 1:9 design shown in FIG. 3 is adopted for a multiplexing circuit as an example.

In some examples, as shown in FIG. 9, within the second signal access region B15, the first voltage contact pad 7241 with which the first power supply leading-out line 312 is connected may be located outside the multiplexing control contact pad 721. A square wave signal contact pad may not be provided between the first voltage contact pad 7241 and the multiplexing control contact pad 721. However, the present embodiment is not limited thereto. In some other examples, at least one square wave signal contact pad may be provided between the first voltage contact pad 7241 and the multiplexing control contact pad 721.

In the display panel of the present example, after being connected with the multiplexing control contact pad 721, the first sub-line of the multiplexing control line extends toward a side close to the bending region B12, without crossing any signal, and directly accesses the first signal access region B14, and is connected with the third sub-line. The third sub-line is connected with the second sub-line at a middle position of the first signal access region B14, so that bypassing the multiplexing data line is achieved and overlap between the multiplexing control line and the multiplexing data line is avoided. This example reduces overlap between the multiplexing control line and a DC signal and a square wave signal transmission line, and may avoid the multiplexing control signal from being crosstalk, thereby avoiding poor split screen at a low gray scale. Rest of description of the display panel of the example may be referred to description of the aforementioned embodiments, and thus will not be repeated herein.

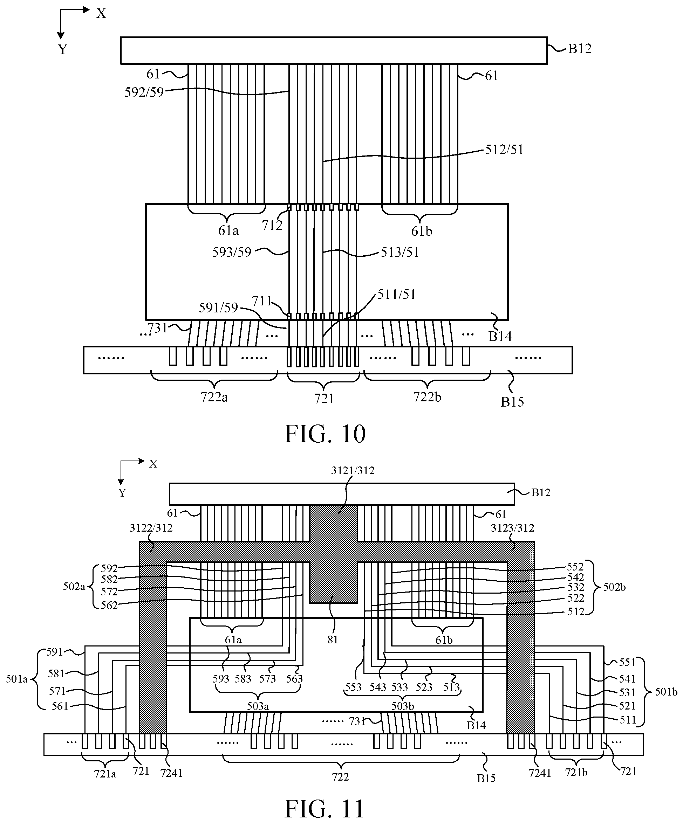

FIG. 10 is an exemplary diagram of another arrangement of a multiplexing control line and a multiplexing data line according to at least one embodiment of the present disclosure. FIG. 10 is illustrated by taking a case of only several multiplexing data lines as an example. FIG. 10 is a schematic diagram showing a general trend of a multiplexing control line and a multiplexing data line in the second fanout region of the display panel. In this embodiment, a quantity of multiplexing data lines is not limited. This example is illustrated by taking a case in which a 1:9 design shown in FIG. 3 is adopted for a multiplexing circuit as an example. In FIG. 10, illustration is made by taking a case in which only the ninth multiplexing control line 59 and the first multiplexing control line 51 are labeled as an example.

In some examples, as shown in FIG. 10, within the second signal access region B15, the multiple first contact pads may be divided into two sets: a first set of first contact pads 722a and a second set of first contact pads 722b. The multiple multiplexing control contact pads 721 may be located between the first set of first contact pads 722a and the second set of first contact pads 722b. Within the first signal access region B14, the multiple first multiplexing adapter pads 711 may be arranged in an extension direction of the second side, and the multiple second multiplexing adapter pads 712 may be arranged in an extension direction of the first side. The multiple first multiplexing adapter pads 711 and the multiple second multiplexing adapter pads 712 may be at least partially aligned in the second direction Y.

In some examples, as shown in FIG. 10, the first sub-lines of the multiple multiplexing control lines (e.g., the first sub-line 511 of the first multiplexing control line 51 and the ninth sub-line 591 of the ninth multiplexing control line 59) may be located in the middle of the multiple first pin connection lines 731. A first sub-line, a second sub-line, and a third sub-line of each multiplexing control line may extend at least in the second direction Y.

In the display panel of this example, the multiplexing control contact pad may be located at a middle position of the second signal access region. After being connected with the multiplexing control contact pad, the multiplexing control line may directly extend toward a direction close to the bending region B12, and after passing through the first signal access region B14, the multiplexing control line extends to be between the first set of multiplexing data lines 61a and the second set of multiplexing data lines 61b. An arrangement mode of the multiplexing control lines in this example may bypass the multiplexing data line and overlap between the multiplexing control line and the multiplexing data line is avoided. Moreover, this example may reduce overlap between the multiplexing control line, and rest DC signals and square wave signal transmission lines, and may avoid the multiplexing control signal from being crosstalk, thereby avoiding poor split screen at a low gray scale. Rest of description of the display panel of the example may be referred to description of the aforementioned embodiments, and thus will not be repeated herein.

FIG. 11 is an exemplary diagram of another arrangement of a multiplexing control line and a multiplexing data line according to at least one embodiment of the present disclosure. FIG. 11 is illustrated by taking a case of only several multiplexing data lines as an example. FIG. 11 is a schematic diagram showing a general trend of a multiplexing control line, a multiplexing data line, and a first power supply leading-out line in the second fanout region of the display panel. In this embodiment, a quantity of multiplexing data lines is not limited. This example is illustrated by taking a case in which a 1:9 design shown in FIG. 3 is adopted for a multiplexing circuit as an example.

In some examples, as shown in FIG. 11, the second fanout region B is also provided with a first shielding electrode 81. The first shielding electrode 81 may be connected with the first power supply leading-out line 312. For example, the first shielding electrode 81 and the first power supply leading-out line 312 may be interconnected to form an integral structure. The first shielding electrode 81 may be located on a side of the first signal access region B14 close to the bending region B12. The first shielding electrode 81 may be connected with a side of the first main body portion 3121 of the first power supply leading-out line 312 away from the bending region B12. A length of the first shielding electrode 81 in the first direction X may be less than or equal to a length of the first main body portion 3121 of the first power supply leading-out line 312 in the first direction X.

**In** some examples, the first power supply leading-out line 312 may be a single-layer trace, for example, located in the first source-drain metal layer or the second source-drain metal layer, and the first shielding electrode 81 may be located in the first power supply leading-out line 312 and of a same layer structure. **In** some other examples, the first shielding electrode 81 and the first power supply leading-out line 312 may be of a different-layer structure, for example, the first shielding electrode 81 may be located in the second source-drain metal layer and connected with the first power supply leading-out line 312 located in the first source-drain metal layer. **In** some other examples, the first power supply leading-out line 312 may be a double-layer trace, e.g., located in the first source-drain metal layer and the second source-drain metal layer, and the first shielding electrode 81 may be located in the first source-drain metal layer or the second source-drain metal layer, and connected with a part of trace of the first power supply leading-out line provided in a same layer.

**In** some examples, as shown in FIG. 11, the first shielding electrode 81 may be located between the first set of second sub-lines 502a and the second set of second sub-lines 502b. An orthographic projection of the first shielding electrode 81 on the base substrate may be not overlapped with an orthographic projection of the first set of second sub-lines 502a and the second set of second sub-lines 502b on the base substrate. **In** this example, by providing the first shielding electrode between two sets of second sub-lines, crosstalk of the multiplexing control signal may be reduced. However, the present embodiment is not limited thereto. **In** some other examples, the first shielding electrode may be located between the second sub-line and the multiplexing data line. For example, one first shielding electrode is provided between the first set of second sub-lines and the first set of multiplexing data lines, and another first shielding electrode is provided between the second set of second sub-lines and the second set of multiplexing data lines, thereby reducing crosstalk between a data signal and a multiplexing control signal.

Rest of description of the display panel of this example may be referred to description of the aforementioned embodiments, and thus will not be repeated herein.

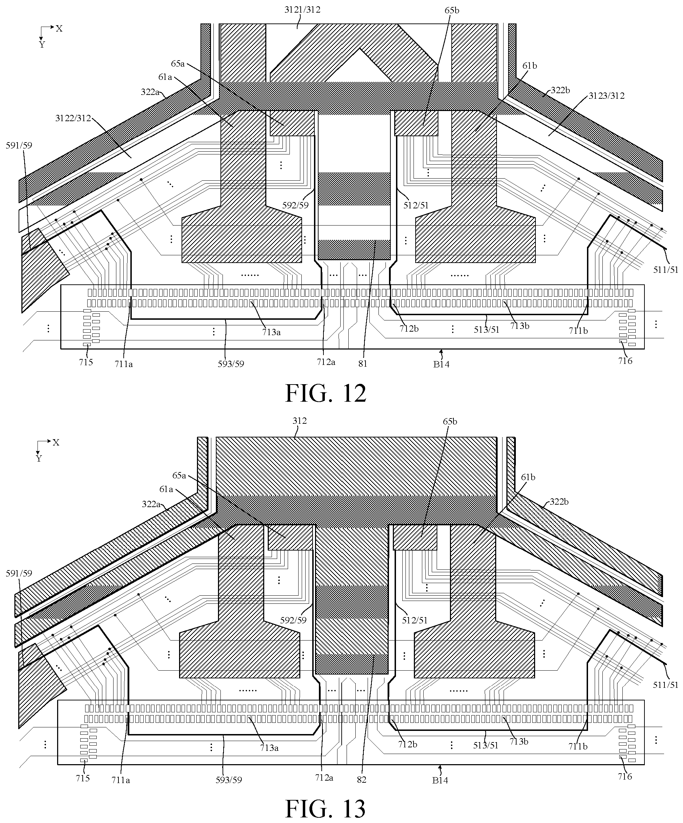

FIG. 12 is a partial schematic view of a second fanout region according to at least one embodiment of the present disclosure. **In** some examples, as shown in FIG. 12, the first power supply leading-out line 312 and the first shielding electrode 81 may both be located in the first source-drain metal layer, and the first power supply leading-out line 312 and the first shielding electrode 81 may be interconnected to form an integral structure. At least a part of the second sub-lines of the multiple multiplexing control lines may be located in the first source-drain metal layer and adjacent to the first shielding electrode 81. An orthographic projection of the first shielding electrode 81 on the base substrate may be not overlapped with an orthographic projection of the second sub-lines of the multiple multiplexing control lines on the base substrate. Rest parts of the display panel of this example may be referred to description of the aforementioned embodiments, and thus will not be repeated herein.

FIG. 13 is another partial schematic view of a second fanout region according to at least one embodiment of the present disclosure. In some examples, as shown in FIG. 13, the first power supply leading-out line 312, the second power supply leading-out line 322a, and the second power supply leading-out line 322b may each be of a double-layer trace structure provided in the first source-drain metal layer and the second source-drain metal layer. The second fanout region is further provided with a second shielding electrode 82 connected with the first shielding electrode. The first shielding electrode may be located in the first source-drain metal layer, and the first shielding electrode and a trace part of the first power supply leading-out line 312 located in the first source-drain metal layer are interconnected to form an integral structure. The second shielding electrode 82 may be located in the second source-drain metal layer, and the second shielding electrode and a trace part of the first power supply leading-out line 312 located in the second source-drain metal layer are interconnected to form an integral structure.

In some examples, the second shielding electrode 82 may be connected with the first shielding electrode through a groove opened in the first planarization layer and the passivation layer. An orthographic projection of the second shielding electrode 82 on the base substrate may include an orthographic projection of the first shielding electrode on the base substrate. For example, the orthographic projection of the second shielding electrode 82 on the base substrate may coincide with the orthographic projection of the first shielding electrode on the base substrate. Or, the orthographic projection of the second shielding electrode 82 on the base substrate may cover the orthographic projection of the first shielding electrode on the base substrate. However, the present embodiment is not limited thereto. For example, the orthographic projection of the first shielding electrode on the base substrate may cover the orthographic projection of the second shielding electrode on the base substrate.

In some examples, the orthographic projection of the second shielding electrode 82 on the base substrate may be not overlapped with an orthographic projection of the second sub-lines (including, for example, the second sub-line 592 and the second sub-line 512) of the multiple multiplexing control lines on the base substrate. For example, the second shielding electrode 82 may be located between the first set of second sub-lines and the second set of second sub-lines.

In this example, by providing the first shielding electrode and the second shielding electrode located in different film layers, and both the first shielding electrode and the second shielding electrode are connected with the first power supply leading-out line, a voltage drop (IR Drop) of a first power supply signal may be reduced, which is conducive to improving uniformity of display image quality, and may further shield signal interference. Rest parts of the display panel of this example may be referred to description of the aforementioned embodiments, and thus will not be repeated herein.

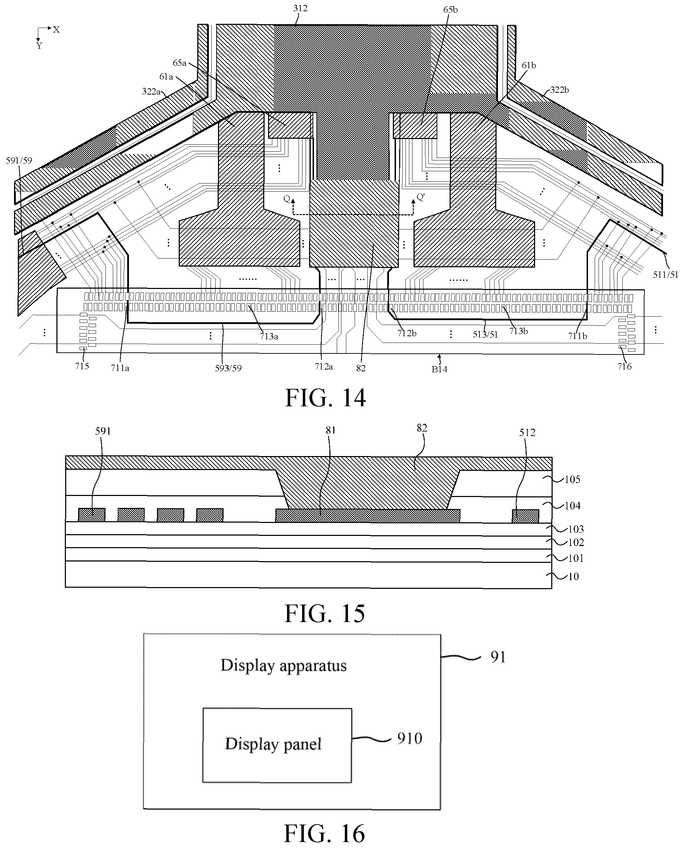

FIG. 14 is another partial schematic view of a second fanout region according to at least one embodiment of the present disclosure. FIG. 15 is a partial cross-sectional view taken along a direction Q-Q' in FIG. 14.

In some examples, as shown in FIG. 14, the first power supply leading-out line 312, the second power supply leading-out line 322a, and the second power supply leading-out line 322b may each be of a double-layer trace structure provided in the first source-drain metal layer and the second source-drain metal layer. The second fanout region is further provided with a second shielding electrode 82 connected with the first shielding electrode. The first shielding electrode may be located in the first source-drain metal layer, and the first shielding electrode and a trace part of the first power supply leading-out line 312 located in the first source-drain metal layer are interconnected to form an integral structure. The second shielding electrode 82 may be located in the second source-drain metal layer, and the second shielding electrode and a trace part of the first power supply leading-out line 312 located in the second source-drain metal layer are interconnected to form an integral structure.

In some examples, as shown in FIGs. 14 and 15, the second shielding electrode 82 may be connected with the first shielding electrode 81 through a groove opened in the first planarization layer and the passivation layer. An orthographic projection of the second shielding electrode 82 on the base substrate may include an orthographic projection of the first shielding electrode on the base substrate. For example, the orthographic projection of the second shielding electrode 82 on the base substrate may cover the orthographic projection of the first shielding electrode 81 on the base substrate.

In some examples, the orthographic projection of the second shielding electrode 82 on the base substrate may be overlapped with an orthographic projection of second sub-lines (including, for example, the second sub-line 592 and the second sub-line 512) of the multiple multiplexing control lines on the base substrate. The second sub-lines of the multiple multiplexing control lines and the first shielding electrode 81 may be of a same layer structure, for example, all located in the first source-drain metal layer. However, the present embodiment is not limited thereto. **In** some other examples, the second sub-lines of the multiple multiplexing control lines may be located in a conductive layer on a side of the first source-drain metal layer close to the base substrate, such as a first gate metal layer or a second gate metal layer.

**In** this example, the second sub-line of the multiplexing control line is shielded by providing the second shielding electrode, so that an influence of a data signal and other external signals or electric fields on a multiplexing control signal may be shielded. Rest parts of the display panel of this example may be referred to description of the aforementioned embodiments, and thus will not be repeated herein.

**In** some other examples, a grouping mode of the multiple multiplexing control lines and an arrangement order of the multiple multiplexing control lines within each set of multiplexing control lines may be adjusted according to a situation.

In some other examples, a 1:6 design may be adopted for the multiplexing circuit. The present embodiment is not limited thereto.

An embodiment also provides a display panel, including a base substrate, multiple sub-pixels and multiple data lines, multiple multiplexing circuits, multiple multiplexing data lines, and multiple multiplexing control lines. The base substrate includes a display region and a first bezel region located on at least one side of the display region, the first bezel region at least includes a first signal access region, and the first signal access region is provided with multiple data contact pads. The multiple sub-pixels and the multiple data lines are located in the display region, and the multiple data lines are connected with the multiple sub-pixels and configured to provide data signals to the multiple sub-pixels. The multiple multiplexing circuits, the multiple multiplexing data lines, and the multiple multiplexing control lines are located in the first bezel region. A multiplexing circuit is connected with at least two multiplexing control lines among the multiple multiplexing control lines, one multiplexing data line, and at least two data lines among the multiple data lines, and is configured to provide a data signal transmitted by the one reset data line to the at least two data lines under control of the at least two multiplexing control lines. The multiple multiplexing data lines are connected with the multiple data contact pads of the first signal access region. An orthographic projection of the multiple multiplexing data lines on the base substrate is not overlapped with an orthographic projection of the multiple multiplexing control lines on the base substrate. A part of at least one multiplexing control line is located in the first signal access region. In some examples, a part of one multiplexing control line is located in the first signal access region, or a part of each of the multiple multiplexing control lines is located in the first signal access region.

In this example, a part of at least one multiplexing control line is provided in the first signal access region to avoid overlapping with multiple multiplexing data lines, thereby reducing an influence of a multiplexing data line on a multiplexing control signal transmitted by a multiplexing control line, and improving display quality of the display panel.

In some exemplary implementation modes, the first bezel region further includes a second signal access region, the second signal access region is located on a side of the first signal access region away from the display region, and the second signal access region is provided with multiple multiplexing control contact pads. A multiplexing control line includes a first sub-line, a second sub-line, and a third sub-line, and the third sub-line is connected between the first sub-line and the second sub-line. The third sub-line is located in the first signal access region. The second sub-line is located on a side of the first signal access region close to the display region. The first sub-line is connected with a multiplexing control contact pad of the second signal access region.

In some exemplary implementation modes, third sub-lines of the multiple multiplexing control lines are divided into a first set of third sub-lines and a second set of third sub-lines, the first set of third sub-lines and the second set of third sub-lines are arranged in a first direction; extension directions of the third sub-lines of the multiple multiplexing control lines intersect with extension directions of second sub-lines.

In some exemplary implementation modes, the extension directions of the third sub-lines of the multiple multiplexing control lines are the same as the extension directions of the second sub-lines.

In some exemplary implementation modes, the multiple multiplexing data lines are divided into a first set of multiplexing data lines and a second set of multiplexing data lines. The second sub-lines of the multiple multiplexing control lines are divided into a first set of second sub-lines and a second set of second sub-lines; the first set of second sub-lines and the second set of second sub-lines are located between the first set of multiplexing data lines and the second set of multiplexing data lines. The first bezel region is provided with a first power supply leading-out line and a first shielding electrode, and the first shielding electrode is connected with the first power supply leading-out line; the first shielding electrode is located on a side of the first signal access region close to the display region; the first shielding electrode is located between the first set of second sub-lines and the second set of second sub-lines.

In some exemplary implementation modes, the first bezel region is further provided with a second shielding electrode, the second shielding electrode is located on a side of the first shielding electrode away from the base substrate, the second shielding electrode is electrically connected with the first shielding electrode; and an orthographic projection of the second shielding electrode on the base substrate is at least partially overlapped with an orthographic projection of the first shielding electrode on the base substrate.

Description of the display panel of the example may be referred to description of the aforementioned embodiments, and thus will not be repeated herein.

FIG. 16 is a schematic diagram of a display apparatus according to at least one embodiment of the present disclosure. As shown in FIG. 16, this embodiment provides a display apparatus 91 including a display panel 910 of the aforementioned embodiments. In some examples, the display panel 910 may be an OLED display panel, such as an OLED display panel with an integrated touch structure. The display apparatus 91 may be any product or component having a display function, such as a mobile phone, a tablet computer, a television, a display, a notebook computer, a digital photo frame, or a navigator, or may be a product or component having touch and display functions.

In some examples, the display apparatus 91 may be a wearable display apparatus, for example, which may be worn on a human body in some manners. For example, the display apparatus 91 may be a smart watch, a smart bracelet, and the like. However, the present embodiment is not limited thereto.

The drawings of the present disclosure only involve structures involved in the present disclosure, and other structures may be referred to conventional designs. The embodiments of the present disclosure, i.e., features in the embodiments, may be combined with each other to obtain new embodiments if there is no conflict. It should be noted that the above embodiments or implementation modes are exemplary only and not restrictive. Therefore, the present disclosure is not limited to what is shown and described in detail herein. Various modifications, substitutions, or omissions may be made in forms and details of implementation without departing from the scope of the present disclosure.

## Claims

1. A display panel, comprising:
a base substrate, comprising a display region and a first bezel region located on a side of the display region;
a plurality of sub-pixels and a plurality of data lines, located in the display region, wherein the plurality of data lines are connected with the plurality of sub-pixels and configured to provide data signals to the plurality of sub-pixels;
a plurality of multiplexing circuits, a plurality of multiplexing data lines, and a plurality of multiplexing control lines, located in the first bezel region;
wherein one of the plurality of multiplexing circuits is connected with at least two multiplexing control lines among the plurality of multiplexing control lines, one of the plurality of multiplexing data lines, and at least two data lines among the plurality of data lines, and is configured to provide a data signal transmitted by the one reset data line to the at least two data lines under control of the at least two multiplexing control lines;
an orthographic projection of the plurality of multiplexing data lines on the base substrate is not overlapped with an orthographic projection of the plurality of multiplexing control lines on the base substrate;
the plurality of multiplexing data lines are divided into a first set of multiplexing data lines and a second set of multiplexing data lines, and a part of at least one multiplexing control line among the plurality of multiplexing control lines is located between the first set of multiplexing data lines and the second set of multiplexing data lines.

2. The display panel according to claim 1, wherein the first bezel region at least comprises a first signal access region and a second signal access region, wherein the second signal access region is located on a side of the first signal access region away from the display region; the second signal access region is provided with a plurality of multiplexing control contact pads;
the multiplexing control line comprises a first sub-line, a second sub-line, and a third sub-line, the third sub-line is connected between the first sub-line and the second sub-line; the third sub-line is located in the first signal access region; the second sub-line is located on a side of the first signal access region close to the display region, and is located between the first set of multiplexing data lines and the second set of multiplexing data lines; and the first sub-line is connected with a multiplexing control contact pad of the second signal access region.

3. The display panel according to claim 2, wherein the first signal access region is provided with a plurality of first multiplexing adapter pads and a plurality of second multiplexing adapter pads;
the first sub-line of the multiplexing control line is connected with the third sub-line through one of the plurality of first multiplexing adapter pads, and the second sub-line of the multiplexing control line is connected with the third sub-line through one of the plurality of second multiplexing adapter pads.

4. The display panel according to claim 3, wherein the first signal access region has a plurality of sides, and the plurality of first multiplexing adapter pads and the plurality of second multiplexing adapter pads are arranged along a same side.

5. The display panel according to claim 4, wherein the first signal access region is further provided with a first set of data contact pads and a second set of data contact pads; the first set of data contact pads are connected with the first set of multiplexing data lines and the second set of data contact pads are connected with the second set of multiplexing data lines;
the plurality of first multiplexing adapter pads are divided into a first set of first multiplexing adapter pads and a second set of first multiplexing adapter pads;
the plurality of second multiplexing adapter pads are located between the first set of data contact pads and the second set of data contact pads;
the first set of first multiplexing adapter pads is located on a side of the first set of data contact pads away from the plurality of second multiplexing adapter pads, and the second set of first multiplexing adapter pads is located on a side of the second set of data contact pads away from the plurality of second multiplexing adapter pads.

6. The display panel according to claim 3, wherein the first signal access region has at least a first side and a second side extending in a same direction, the second side is located on a side of the first side away from the display region; the plurality of first multiplexing adapter pads are arranged along the second side and the plurality of second multiplexing adapter pads are arranged along the first side.

7. The display panel according to claim 6, wherein the plurality of first multiplexing adapter pads and the plurality of second multiplexing adapter pads are at least partially aligned in an extension direction of the second sub-line.

8. The display panel according to any one of claims 2 to 5, wherein the first bezel region is provided with a plurality of Direct Current (DC) signal transmission lines; an orthographic projection of the first sub-line of the multiplexing control line on the base substrate is overlapped with an orthographic projection of at least one DC signal transmission line on the base substrate.

9. The display panel according to claim 8, wherein the second signal access region is further provided with a plurality of DC signal contact pads arranged in a first direction; the plurality of DC signal contact pads are configured to be connected with the plurality of DC signal transmission lines; the plurality of multiplexing control contact pads are located on a side of the plurality of DC signal contact pads close to an edge of the display panel.

10. The display panel according to claim 9, wherein the first bezel region is further provided with a plurality of square wave signal transmission lines, and an orthographic projection of the first sub-line of the multiplexing control line is further overlapped with an orthographic projection of at least one square wave signal transmission line on the base substrate.

11. The display panel according to claim 10, wherein the second signal access region is further provided with a plurality of square wave signal contact pads arranged in the first direction; the plurality of square wave signal contact pads are configured to be connected with the plurality of square wave signal transmission lines; at least one square wave signal contact pad is provided between the plurality of multiplexing control contact pads and the plurality of DC signal contact pads.

12. The display panel according to claim 2, wherein the first bezel region is provided with a plurality of Direct Current (DC) signal transmission lines; an orthographic projection of the first sub-line of the multiplexing control line on the base substrate is not overlapped with an orthographic projection of the plurality of DC signal transmission lines on the base substrate.

13. The display panel according to claim 12, wherein the second signal access region is further provided with a plurality of DC signal contact pads arranged in a first direction; the plurality of DC signal contact pads are configured to be connected with the plurality of DC signal transmission lines; the plurality of multiplexing control contact pads are located on a side of the plurality of DC signal contact pads away from an edge of the display panel.

14. The display panel according to any one of claims 2 to 13, wherein the first bezel region is provided with a first power supply leading-out line and a first shielding electrode, and the first shielding electrode is connected with the first power supply leading-out line; the first shielding electrode is located on a side of the first signal access region close to the display region; second sub-lines of the plurality of multiplexing control lines are divided into a first set of second sub-lines and a second set of second sub-lines; the first shielding electrode is located between the first set of second sub-lines and the second set of second sub-lines.

15. The display panel according to claim 14, wherein an orthographic projection of the first shielding electrode on the base substrate is not overlapped with an orthographic projection of the second sub-lines of the plurality of multiplexing control lines on the base substrate.

16. The display panel according to claim 14, wherein the first bezel region is further provided with a second shielding electrode, the second shielding electrode is located on a side of the first shielding electrode away from the base substrate, and the second shielding electrode is electrically connected with the first shielding electrode; an orthographic projection of the second shielding electrode on the base substrate is at least partially overlapped with an orthographic projection of the first shielding electrode on the base substrate.

17. The display panel according to claim 16, wherein the second shielding electrode is located on a side of the second sub-lines of the plurality of multiplexing control lines away from the base substrate, and the orthographic projection of the second shielding electrode on the base substrate is overlapped with an orthographic projection of a second sub-line of at least one multiplexing control line among the plurality of multiplexing control lines on the base substrate.

18. A display apparatus, comprising a display panel according to any one of claims 1 to 17.

19. The display apparatus according to claim 18, further comprising: a drive chip and a flexible circuit board which are connected with the display panel, wherein the first bezel region of the display panel at least comprises: a first signal access region and a second signal access region, and the second signal access region is located on a side of the first signal access region away from a display region; an orthographic projection of the drive chip on the display panel is located in the first signal access region and at least a part of pins of the flexible circuit board are located in the second signal access region.

20. A display panel, comprising:
a base substrate, comprising a display region and a first bezel region located on at least one side of the display region, wherein the first bezel region at least comprises a first signal access region, and the first signal access region is provided with a plurality of data contact pads;
a plurality of sub-pixels and a plurality of data lines, located in the display region, wherein the plurality of data lines are connected with the plurality of sub-pixels and configured to provide data signals to the plurality of sub-pixels;
a plurality of multiplexing circuits, a plurality of multiplexing data lines, and a plurality of multiplexing control lines, located in the first bezel region;
one of the plurality of multiplexing circuits is connected with at least two multiplexing control lines among the plurality of multiplexing control lines, one of the plurality of multiplexing data lines, and at least two data lines among the plurality of data lines, and is configured to provide a data signal transmitted by the one reset data line to the at least two data lines under control of the at least two multiplexing control lines;
the plurality of multiplexing data lines are connected with the plurality of data contact pads of the first signal access region;
an orthographic projection of the plurality of multiplexing data lines on the base substrate is not overlapped with an orthographic projection of the plurality of multiplexing control lines on the base substrate; a part of at least one multiplexing control line among the plurality of multiplexing control lines is located in the first signal access region.

21. The display panel according to claim 20, wherein the first bezel region further comprises a second signal access region, the second signal access region is located on a side of the first signal access region away from the display region, and the second signal access region is provided with a plurality of multiplexing control contact pads;
the multiplexing control line comprises a first sub-line, a second sub-line, and a third sub-line, and the third sub-line is connected between the first sub-line and the second sub-line; the third sub-line is located in the first signal access region; the second sub-line is located on a side of the first signal access region close to the display region; the first sub-line is connected with a multiplexing control contact pad of the second signal access region.

22. The display panel according to claim 21, wherein third sub-lines of the plurality of multiplexing control lines are divided into a first set of third sub-lines and a second set of third sub-lines, and the first set of third sub-lines and the second set of third sub-lines are arranged in a first direction; extension directions of the third sub-lines of the plurality of multiplexing control lines intersect with extension directions of second sub-lines.

23. The display panel according to claim 21, wherein the extension directions of the third sub-lines of the plurality of multiplexing control lines are the same as the extension directions of the second sub-lines.

24. The display panel according to claim 21, wherein the plurality of multiplexing data lines are divided into a first set of multiplexing data lines and a second set of multiplexing data lines;
second sub-lines of the plurality of multiplexing control lines are divided into a first set of second sub-lines and a second set of second sub-lines; the first set of second sub-lines and the second set of second sub-lines are located between the first set of multiplexing data lines and the second set of multiplexing data lines;
the first bezel region is provided with a first power supply leading-out line and a first shielding electrode, and the first shielding electrode is connected with the first power supply leading-out line; the first shielding electrode is located on a side of the first signal access region close to the display region; the first shielding electrode is located between the first set of second sub-lines and the second set of second sub-lines.

25. The display panel according to claim 24, wherein the first bezel region is further provided with a second shielding electrode, the second shielding electrode is located on a side of the first shielding electrode away from the base substrate, and the second shielding electrode is electrically connected with the first shielding electrode; an orthographic projection of the second shielding electrode on the base substrate is at least partially overlapped with an orthographic projection of the first shielding electrode on the base substrate.
